# EUROPEAN PATENT APPLICATION

(11) **EP 4 191 683 A1**
(43) Date of publication of application: **07.06.2023**
(21) Application number: 22203655.0
(22) Date of filing: 25.10.2022
(51) Int. Cl.: H01L 29/775, H01L 29/66, H01L 29/06, H01L 29/10, H01L 29/08

(54) **RECESSED INNER GATE SPACERS AND PARTIAL REPLACEMENT CHANNEL IN NON-PLANAR TRANSISTORS**

(30) Priority: 02.12.2021 US 202117540560
(71) Applicant: INTEL Corporation, Santa Clara, CA 95054 (US)
(72) Inventor: MAJHI, Prashant, San Jose, 95121 (US); GLASS, Glenn A., Portland, 97229 (US); MURTHY, Anand S., Portland, 97229 (US); SHAH, Rushabh, Hillsboro, 97124 (US)
(74) Representative: 2SPL Patentanwälte PartG mbB

(57) **Abstract**

A semiconductor structure includes a body including semiconductor material, and a gate structure at least in part wrapped around the body. The semiconductor structure further includes a source region and a drain region, the body laterally extending between the source and drain regions. The body has a middle region between first and second tip regions. In an example, the source region at least in part wraps around the first tip region of the body, and/or the drain region at least in part wraps around the second tip region of the body. In another example, the body includes a core structure and a peripheral structure (e.g., cladding or layer that wraps around the core structure in the middle region of the body) that is compositionally different from the core structure. The body can be, for instance, a nanoribbon, nanosheet, or nanowire or a gate-all-around device or a forksheet device.

## Description

### BACKGROUND

Semiconductor devices are electronic components that exploit the electronic properties of semiconductor materials, such as silicon (Si), germanium (Ge), gallium arsenide (GaAs), and indium phosphide (InP). A field-effect transistor (FET) is a semiconductor device that includes three terminals: a gate, a source, and a drain. A FET uses an electric field applied by the gate to control the electrical conductivity of a channel through which charge carriers (e.g., electrons or holes) flow between the source and drain. In instances where the charge carriers are electrons, the FET is referred to as an n-channel device; and in instances where the charge carriers are holes, the FET is referred to as a p-channel device. Some FETs have a fourth terminal called the body or substrate, which can be used to bias the transistor. In addition, metal-oxide-semiconductor FETs (MOSFETs) include a gate dielectric between the gate and the channel. MOSFETs may also be known as metal-insulator-semiconductor FETs (MISFETSs) or insulated-gate FETs (IGFETs). Complementary MOS (CMOS) structures use a combination of p-channel MOSFET (PMOS) and n-channel MOSFET (NMOS) devices to implement logic gates and other digital circuits.

A FinFET is a MOSFET transistor built around a thin strip of semiconductor material (generally referred to as a fin). The conductive channel of the FinFET device resides on the outer portions of the fin adjacent to the gate dielectric. Specifically, current runs along/within both sidewalls of the fin (sides perpendicular to the substrate surface) as well as along the top of the fin (side parallel to the substrate surface). Because the conductive channel of such configurations includes three different planer regions of the fin (e.g., top and two sides), such a FinFET design is sometimes referred to as a tri-gate transistor. A nanoribbon transistor (sometimes referred to as a gate-all-around (GAA) or nanowire transistor) is configured similarly to a fin-based transistor, but instead of a finned channel region, one or more nanoribbons or nanowires extend between the source and the drain regions. In nanoribbon transistors, the gate material wraps around each nanoribbon (hence, gate-all-around).

### BRIEF DESCRIPTION OF THE DRAWINGS

Figs. 1A, 1B, 1C, and 1D illustrate various perspective and cross-sectional views of a non-planar device, where inner gate spacers of the non-planar device are recessed, such that a source region and a drain region of the non-planar device at least in part clad respective tip regions of a channel body of the non-planar device on multiple sides, in accordance with an embodiment of the present disclosure.
Fig. 2 illustrates a flowchart depicting a method of forming the example non-planar device of Figs. 1A-1D, in accordance with an embodiment of the present disclosure.
Figs. 3A-3I illustrate cross-sectional views of an example non-planar device (e.g., the non-planar device of Figs. 1A-1D) in various stages of processing, in accordance with an embodiment of the present disclosure.
Figs. 4A-4F illustrate various perspective and cross-sectional views of a non-planar device, where an individual channel body of the non-planar device comprises a core structure and a peripheral structure at least in part wrapped around the core structure, in accordance with an embodiment of the present disclosure.
Figs. 5A and 5B illustrate perspective and cross-sectional views, respectively, of an integrated circuit (IC) structure comprising a plurality of non-planar devices, where an individual channel body of an individual non-planar device comprises (i) a core structure and (ii) a peripheral structure at least in part wrapped around the core structure, in accordance with an embodiment of the present disclosure.
Fig. 6 illustrates cross-sectional view of a non-planar device, where (i) inner gate spacers of the non-planar device are recessed, such that a source region and a drain region of the non-planar device at least in part clad tip regions of a channel body of the non-planar device on multiple sides, and (ii) an individual channel body of the non-planar device comprises a core structure and a peripheral structure at least in part wrapped around the core structure, in accordance with an embodiment of the present disclosure.
Fig. 7 illustrates a flowchart depicting a method of forming the example non-planar device of Figs. 4A-4F, in accordance with an embodiment of the present disclosure.
Figs. 8A-8F illustrate cross-sectional views of an example non-planar device (e.g., the non-planar device of Figs. 4A-4F) in various stages of processing, in accordance with an embodiment of the present disclosure.
Fig. 9 illustrates a computing system implemented with integrated circuit structures and/or transistor devices formed using the techniques disclosed herein, in accordance with some embodiments of the present disclosure.

These and other features of the present embodiments will be understood better by reading the following detailed description, taken together with the figures herein described. In the drawings, each identical or nearly identical component that is illustrated in various figures may be represented by a like numeral. For purposes of clarity, not every component may be labeled in every drawing. Furthermore, as will be appreciated, the figures are not necessarily drawn to scale or intended to limit the described embodiments to the specific configurations shown. For instance, while some figures generally indicate straight lines, right angles, and smooth surfaces, an actual implementation of the disclosed techniques may have less than perfect straight lines and right angles (e.g., curved or tapered sidewalls and round corners), and some features may have surface topography or otherwise be non-smooth, given real-world limitations of fabrication processes. Further still, some of the features in the drawings may include a patterned and/or shaded fill, which is merely provided to assist in visually identifying the different features. In short, the figures are provided merely to show example structures.

### DETAILED DESCRIPTION

Integrated circuit structures including non-planar transistor devices are provided herein. In one embodiment, a semiconductor structure comprises a body comprising a semiconductor material (e.g. nanoribbon or nanosheet), and a gate structure at least in part wrapped around the body. In an example, the gate structure includes (i) a gate electrode and (ii) a gate dielectric between the body and the gate electrode. The semiconductor structure further comprises a source region and a drain region. The body laterally extends between the source and drain regions. The body has a first tip region, a second tip region, and a middle region between the first and second tip regions. In an example, the source region at least in part wraps around the first tip region of the body and/or the drain region at least in part wraps around the second tip region of the body.

In another embodiment, a semiconductor structure comprises a body (e.g. nanoribbon or nanosheet) comprising a semiconductor material and a gate structure at least in part wrapped around the body. In an example, the gate structure includes (i) a gate electrode and (ii) a gate dielectric between the body and the gate electrode. The semiconductor structure comprises further comprises a source region and a drain region. The body laterally extends between the source and drain regions. The body has a first tip region, a second tip region, and a middle region laterally between the first and second tip regions. In an example, the body comprises (i) a core structure that includes the first tip region, the second tip region, and a section of the middle region, and (ii) a peripheral structure that includes another section of the middle region, the peripheral structure compositionally different from the core structure. In an example, the peripheral structure is like a cladding or layer that wraps around the core structure in the middle region of the body.

In yet another embodiment, an integrated circuit structure comprises a first non-planar semiconductor device and a second non-planar semiconductor device. In an example, the first non-planar semiconductor device comprises a first source region and a first drain region, and a first body laterally extending between the first source region and the first drain region. In one such example, the first body comprises (i) a first core structure including a continuous section with a first end abutting the first source region and a second end abutting the first drain region, and (ii) a first peripheral structure wrapped around a middle section of the first core structure. In addition, the second non-planar semiconductor device comprises a second source region and a second drain region, and a second body laterally extending between the second source region and the second drain region. The second body comprises (i) a second core structure including a continuous section with a first end abutting the second source region and a second end abutting the second drain region, and (ii) a second peripheral structure wrapped around a middle section of the second core structure. In some such examples, the first peripheral structure is compositionally different from the second peripheral structure.

In yet another embodiment, a method of forming a semiconductor structure is provided. The method comprises forming a plurality of bodies, where each body includes (i) a first tip region, (ii) a second tip region, (iii) a middle region laterally between the first and second tip regions, (iv) a first near-tip region laterally between the first tip region and the middle region, and (v) a second near-tip region laterally between the second tip region and the middle region. The method further comprises forming an inner gate spacer on a side of the plurality of bodies. In an example, the inner gate spacer is above and below the first tip region and the first near-tip region of each body of the plurality of bodies. The method further comprises recessing the first inner gate spacer to reexpose the first tip regions of each body of the plurality of bodies. For example, the recessed first inner gate spacer is still above and below the first near-tip region of each body of the plurality of bodies but not above and below the first tip region of each body of the plurality of bodies. The method further comprises forming a source region that wraps around the first tip region of each body of the plurality of bodies.

In a further embodiment, a method of forming a semiconductor structure is provided. The method comprises forming a core structure of a body. In an example, the core structure has a first tip region, a second tip region, a middle region laterally between the first and second tip regions. The method further comprises forming a first inner gate spacer above and below the first tip region of the core structure, and a second inner gate spacer above and below the second tip region of the core structure, and thinning the middle region of the core structure, to form a thinned middle region of the core structure. The method further comprises forming a peripheral structure of the body that at least in part wraps around the thinned middle region of the core structure.

Numerous variations, embodiments, and applications will be apparent in light of the present disclosure.

### General Overview

Field effect transistors (FETs) have been scaled to smaller and smaller sizes to achieve faster circuit operation. Such scaling has resulted in the development of gate-all-around (GAA) transistors, examples of which include nanowire or nanoribbon transistors. For example, the GAA channel region can have a vertical stack of nanoribbons that extend horizontally between the source and drain regions, and a gate structure that is between the source and drain regions and wraps around the nanoribbons. GAA transistors sometimes suffer from mismatch in performance characteristics (e.g., strong NMOSFET and poor PMOSFET), due to reduced hole mobility in (100) plane of the channel body. For example, lack of strain in the channel body can reduce mobility of charge carriers within the channel body, and lack of strain affects hole mobility of PMOS transistors more than electron mobility of NMOS transistors.

Accordingly, techniques are provided herein to enhance process-induced strain of channel bodies of GAA transistors. While the techniques may especially be suitable for PMOS transistors (e.g., as lack of strain affects hole mobility of PMOS transistors more than electron mobility of NMOS transistors), the teachings of this disclosure may be applicable to increase strain in channel bodies of both PMOS and NMOS GAA transistors. As discussed, increasing strain (e.g., uniaxial strain) in the channel bodies facilitates mobility of charge carriers in the channel bodies, thereby improving the performance of the GAA transistors.

In one embodiment, strain in a channel body of a GAA transistor is increased by cladding the source region and the drain region on multiple sides of tip regions of the channel bodies. For example, usually, in a GAA transistor, the horizontal surfaces of tip regions of a channel body are covered by the inner gate spacers (and not by the source or drain regions). In one embodiment, the inner gate spacers in the GAA transistor are recessed, such that the inner gate spacers no longer cover the tip regions of the channel body. Instead, a recessed inner gate spacer covers a "near-tip region" of the body, where the near-tip region is laterally between the tip region and a middle region of the body. Thus, the tip regions on both sides of the channel body are now free (i.e., not covered by the inner gate spacers).

Note that due to the recessing of the inner gate spacers, a width of individual inner gate spacer is now less than a width of individual gate spacer. For example, a width of an inner gate spacers is now at least 5%, or at least 10% less than a width of a gate spacer. The widths are measured in a horizontal direction that is parallel to a length of the channel body.

Subsequently, the source and drain regions are formed (e.g., epitaxially formed). Note that the source and drain regions can epitaxially grow from and into the recessed area that was formed by recessing the inner gate spacers. Because the source and drain regions expand to the recessed area, the source and drain regions now wrap around the corresponding tip regions of the channel body. For example, the source region now clads on or otherwise covers multiple sides of a first tip region of the body, and the drain region now clads on or otherwise covers multiple sides of a second tip region of the body. Thus, the first tip region now extends within the source region, and the second tip region now extends within the drain region. Accordingly, a section of the source region is now vertically between two tip regions of two adjacent bodies; likewise, a given tip region of a body is vertically between portions of a given source region. Similarly, a section of the drain region is now vertically between two other tip regions of the two adjacent bodies; likewise, a given tip region of a body is vertically between portions of a given drain region.

Because the source region and the drain region now clad the corresponding tip regions of a channel body on multiple sides, the source and drain regions have better control of the channel body and can better induce strain, such as uniaxial strain, on the channel body, according to some embodiments. The process-induced strain facilitates carrier mobility within the channel body, thereby improving performance of the transistors. This helps in improving and/or maintaining carrier mobility in NMOS transistors, while improving carrier mobility in PMOS transistors. This in turn aids in matching performance of PMOS and NMOS GAA and forksheet transistors, which facilitates in matching channel body width and uniformity in the PMOS and NMOS GAA and forksheet transistors.

As discussed herein previously, inducing strain in the channel body of a GAA transistor aids in mobility of charge carriers in the channel body. In an example, mobility of charge carriers in the channel body also be increased by integrating high channel mobility material in the channel body. Accordingly, techniques are also provided herein to enhance mobility of charge carriers, by integrating high channel mobility material in the channel body of a GAA transistor.

In one embodiment, the GAA transistor has a channel body comprising core structure and a peripheral structure. The core structure has a shape of a dumb-bell or "H," where tip regions of the core structure have a vertical height that is greater than a vertical height of a middle region of the core structure. For example, the tip regions of the core structure of the body have the respective inner gate spacers on above and below the tip regions. The middle section of the core structure is thinned, and the peripheral structure is formed that wraps around the thinned middle section of the core structure.

For example, during formation of the GAA transistor, after the nanoribbons are released by removing the dummy gate and the sacrificial material, the middle regions of the nanoribbons are exposed within the channel region. Note that the inner spacers cover the tip regions, and hence, the tip regions are not exposed. Subsequently, after release of the nanoribbons, the middle regions of the nanoribbons are thinned. An etchant used for the thinning process may be selective to the inner gate spacers, such that the etching process does not etch the inner gate spacers and the tip regions of the nanoribbons that are covered by the inner gate spacers. After thinning of the middle region of the nanoribbons, each thinned nanoribbon has the previously discussed dumb-bell or "H" shape, where the tip regions have vertical height that is greater than the middle region.

Subsequently, the peripheral structure is deposited on the thinned middle region of each nanoribbon. Thus, the peripheral structure wraps around the thinned middle region of a nanoribbon. Subsequently, the final gate stack is formed, where the gate dielectric wraps around the peripheral structures of the nanoribbons, and the gate electrode wraps around the gate dielectric.

In one embodiment, the core structure may include group IV semiconductor material (e.g., Si, SiGe, Ge, etc.), and the peripheral structure may include group IV semiconductor material and/or group III-V semiconductor material (e.g., GaAs, InGaAs, InP, etc.). Material for peripheral structure of a PMOS device may be different from material for peripheral structure of an NMOS device. In one embodiment, the material for peripheral structures are selected to impart high mobility to the charge carriers (i.e., holes or electrons) within channel bodies. The core structure forms a skeleton of a channel body, and the peripheral structure forms high mobility area of the channel body. In an example, the core structure is under strain, which increases a carrier mobility through the core structure. The high mobility peripheral structure further increases carrier mobility. In an example, the cladded peripheral structure increases an overall mobility of the channel body, which improves performance of the GAA device. For example, a transistor drive strength is dominated by the high mobility cladding of the peripheral structure.

The use of "group IV semiconductor material" (or "group IV material" or generally, "IV") herein includes at least one group IV element (e.g., silicon, germanium, carbon, tin), such as silicon (Si), germanium (Ge), silicon-germanium (SiGe), and so forth. The use of "group III-V semiconductor material" (or "group III-V material" or generally, "III-V") herein includes at least one group III element (e.g., aluminum, gallium, indium) and at least one group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), gallium nitride (GaN), and so forth. Note that group III may also be known as the boron group or IUPAC group 13, group IV may also be known as the carbon group or IUPAC group 14, and group V may also be known as the nitrogen family or IUPAC group 15, for example.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

Note that the use of "source/drain" herein is simply intended to refer to a source region or a drain region or both a source region and a drain region. To this end, the forward slash ("/") as used herein means "and/or" unless otherwise specified, and is not intended to implicate any particular structural limitation or arrangement with respect to source and drain regions, or any other materials or features that are listed herein in conjunction with a forward slash.

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. In particular, in some embodiments, such tools may be used to detect source and drain regions cladding corresponding tip regions of a channel body from multiple sides, and mismatch between horizontal widths of gate spacers and inner gate spacers. In some embodiments, such tools may also be used to detect a channel body having multiple layers, such as a core structure, and a peripheral structure wrapping around the core structure in a middle region of the channel body. Numerous configurations and variations will be apparent in light of this disclosure.

### Architecture and Methodology

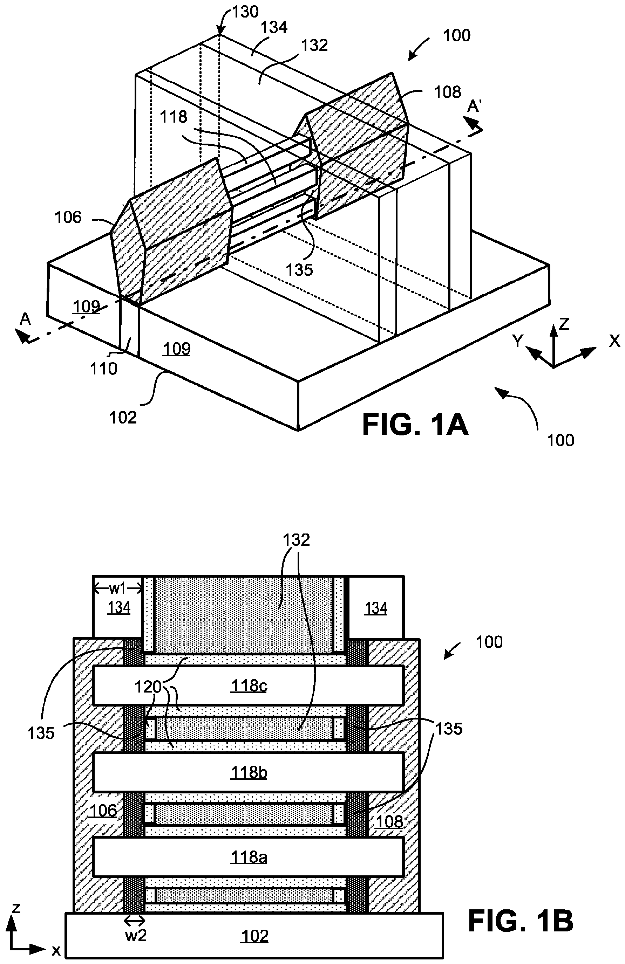

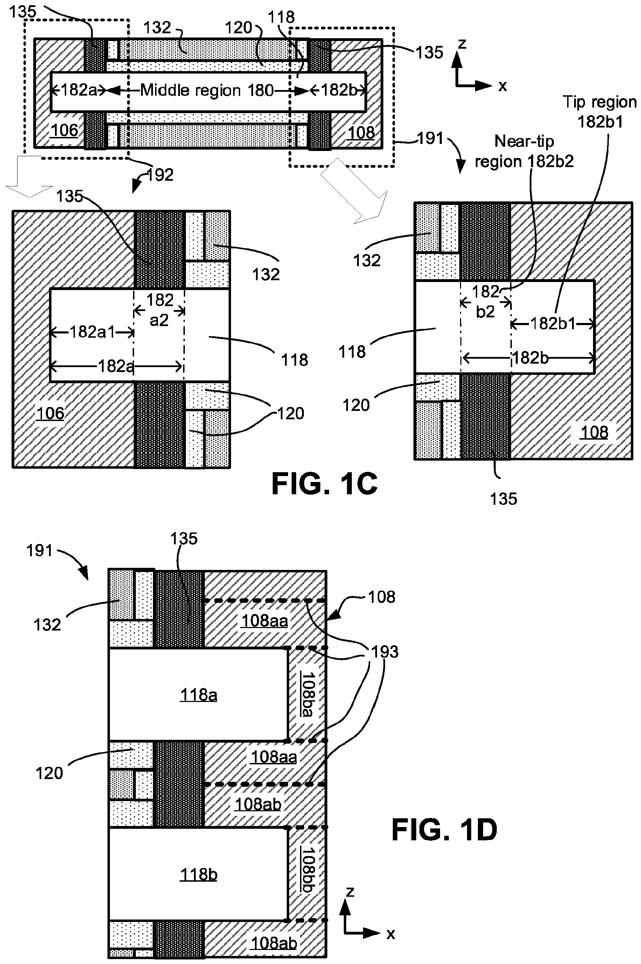

Fig. 1A illustrates perspective view of a non-planar device 100, where inner gate spacers 135 of the non-planar device 100 are recessed, such that a source region 106 and a drain region 108 of the non-planar device 100 at least in part clad tip regions of a channel body 118 of the non-planar device 100 on multiple sides, in accordance with an embodiment of the present disclosure. Fig. 1B illustrates cross-sectional view of the non-planar device 100 of Fig. 1A, in accordance with an embodiment of the present disclosure. Figs. 1C and 1D illustrate a channel body 118 and tip regions 182 of the channel body 118 of the non-planar device 100 of Figs. 1A and 1B in further detail, in accordance with an embodiment of the present disclosure. The cross-sectional views of the non-planar device 100 (also referred to herein as "device 100") of Figs. 1B, 1C, and 1D are along line A-A' of Fig. 1A.

In some examples, the non-planar device 100 is a GAA device, such as a GAA transistor. Although some embodiments of this disclosure have been discussed with respect to a nanoribbon GAA transistor, the teachings of this disclosure can also be employed in other types of GAA or non-planar transistors as well, such as nanowire transistors, nanosheet transistors, or forksheet transistors, as will be appreciated in light of this disclosure.

Note that the perspective view of Fig. 1A does not illustrate the recessed inner gate spacers 135 (although label 135 in Fig. 1A points to a location of the inner gate spacers 135) and the gate dielectric 120, and also does not illustrate the source and drain regions 106, 108 cladding the tip regions of the channel bodies 118 on multiple sides. Furthermore, the gate electrode 132 and the gate spacers 134 are illustrated to be transparent in Fig. 1A, in order to show the geometry of the nanoribbons 118 extending through the gate electrodes and gate spacers. All these features are illustrated in Figs. 1B, 1C, and 1D. Thus, Fig. 1A introduces the overall three-dimensional (3D) non-planar structure of the device 100, while Figs. 1B-1D illustrate the features discussed herein in further detail.

As can be seen, the device 100 is formed on a base or substrate 102. Any number of semiconductor devices can be formed on the substrate 102, although only a single device 100 is illustrated as an example. In an example, the substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, any of the substrates can be a semiconductor-on-insulator (SOI) substrate having a desired semiconductor layer over a buried insulator layer (e.g., silicon over silicon dioxide). Alternatively, the substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used.

The semiconductor material in the device 100 may be formed from the substrate 102. For example, the device 100 may include semiconductor material, such as nanoribbons or nanowires that can be, for example, native to the corresponding substrate (formed from the substrate itself). Alternatively, the semiconductor material can be formed of material deposited onto an underlying substrate. In one such example case, a blanket layer of silicon germanium (SiGe) can be deposited onto a silicon substrate, and then patterned and etched to form a plurality of SiGe fins or nanoribbons. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out.

The device 100 includes a subfin region 110, above which the nanoribbons 118 of the device 100 are vertically stacked. According to some embodiments, subfin region 110 comprises the same semiconductor material as the substrate 102. As illustrated, the device 100 may be separated from any adjacent device (not illustrated) by a dielectric fill 109. Dielectric fill 109 provides shallow trench isolation (STI) between any adjacent semiconductor devices. Dielectric fill 109 can be any suitable dielectric material, such as silicon dioxide, aluminum oxide, or silicon oxycarbonitride.

The device 100 includes a channel region laterally extending between and connecting source region 106 and drain region 108. The channel region includes two or more channel bodies, such as nanoribbons 118 (e.g., nanoribbons 118a, 118b, 118c), that extend horizontally and are arranged in a vertical stack. According to some embodiments, the source region 106 and drain region 108 are epitaxial regions that are provided using an etch-and-replace process. In other embodiments, one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. Any semiconductor materials suitable for source and drain regions can be used (e.g., group IV and group III-V semiconductor materials). In an example, the source and drain regions may be appropriately doped, based on a type of device (e.g., PMOS or NMOS).

The device 100 includes channel bodies 118, such as nanoribbons 118a, 118b, 118c, generally referred to as nanoribbons 118. Although the device 100 is illustrated to include three nanoribbons, the channel region of the device 100 can have any different number of nanoribbons, such as one, two, four, or higher. Although the nanoribbons 118 extend horizontally and are stacked vertically in device 100, the present disclosure contemplates nanoribbons in a variety of configurations that include planar nanoribbon transistors, nanoribbons that extend vertically and are stacked horizontally, and other arrangements, as will be appreciated. In an example, the nanoribbons 118 comprise an appropriately doped semiconductor material, such as appropriately doped silicon.

In the device 100, a gate structure 130 contacts and at least in part surrounds each nanoribbon 118 between the source and drain regions 106, 108, where the gate structure 130 includes gate dielectric 120, a gate electrode 132, gate spacers 134, and inner gate spacers 135.

Fig. 1C illustrates a single nanoribbon 118. As seen, the nanoribbon 118 (and other nanoribbons as well of the device 100) comprise a middle region 180 between end regions 182a and 182b. For example, the end region 182a of individual nanoribbons are in contact with and abuts the source region 106 and inner gate spacer 135 adjacent to the source region, and the end region 182b of individual nanoribbons are in contact with and abuts the drain region 108 and inner gate spacer 135 adjacent to the drain region. The dielectric layer 120 wraps around the middle region 180 of individual nanoribbons, but doesn't wrap around the end regions 182a, 182b of individual nanoribbons. The end regions of the nanoribbons will be discussed in further detail herein later.

In an example, the gate dielectric 120 may include a single material layer or multiple stacked material layers. In some embodiments, gate dielectric 120 includes a first dielectric layer such as silicon oxide, and a second dielectric layer that includes a high-K material such as hafnium oxide. The hafnium oxide may be doped with an element to affect the threshold voltage of the given semiconductor device. According to some embodiments, the doping element used in gate dielectric is lanthanum. The gate dielectric 120 is present around middle regions of each nanoribbon, and although not illustrated, may also be present over subfin portion 110. In some embodiments and although not illustrated, gate dielectric 120 is also present over a top surface of dielectric fill 109. In some embodiments and although not illustrated in Figs. 1A-1D, one or more work function metals may be included around the individual nanoribbons of the device 100.

According to some embodiments, a gate electrode 132 extends over and wraps around the nanoribbons 118. Gate electrode 132 may include any sufficiently conductive material such as a metal, metal alloy, or doped polysilicon.

As seen in Figs. 1B-1D, the gate structure also includes inner gate spacers 135 that is laterally between and separate the source region 106 and the gate electrode 132, as well as laterally between and separate the drain region 108 and the gate electrode 132. The inner gate spacers isolate the gate electrode 132 from the source and drain regions 106, 108. For example, a first inner gate spacer isolates the gate electrode 132 from the source region 106, and a second inner gate spacer isolates the gate electrode 132 from the drain region 108.

In an example, the gate spacers 135 and the gate spacers 134 are compositionally same. In another example, the gate spacers 135 and the gate spacers 134 are compositionally different.

Referring again to Fig. 1C, illustrated in the bottom-left side of the figure is a zoomed-in view of a section 192 of the device 100, and illustrated in the bottom-right side of the figure is a zoomed-in view of a section 191 of the device 100. Note that although Fig. 1C illustrates a single specific nanoribbon 181 and zoomed-in views of two sections of the nanoribbon 181, the discussion with respect to Fig. 1C applies to other nanoribbons of the device 100 as well.

Referring to sections 191 and 192, the gate dielectric 120 wraps around the middle region 180 of nanoribbon 118, but does not wrap around the end regions 182a, 182b. The end region 182a has a tip region 182a1 and a near-tip region 182a2 (see section 192), and the end region 182b has a tip region 182b1 and a near-tip region 182b2 (see section 191). Thus, when traversing laterally from left to right, the nanoribbon 118 comprises a tip region 182a1, a near-tip region 182a2, a middle region 180, near-tip region 182b2, and a tip region 182b1.

Referring now to the section 192, the inner gate spacer 135 are above and below the near-tip region 182a2 of the end region 182a. The source region 106 clads the tip region 182a1 of the end region 182a on multiple sides. For example, the source region 106 wraps around the tip region 182a1 of the end region 182a. As illustrated, the source region 106 is present on five sides of the tip region 182a1 of the end region 182a. For example, the source region 106 is present on front, back, top, bottom, and left side of the tip region 182a1, while the right side of the tip region 182a1 is conjoined to the near-tip region 182a2. Thus, the tip region 182a1 of the end region 182a extends within the source region 106.

Referring to Fig. 1B, the source region 106 is vertically between a tip region of a nanoribbon 118a and another tip region of another nanoribbon 118b. Thus, an imaginary vertical line passes through various sections of the source region and the tip regions of multiple (such as all) the nanoribbons 118.

Referring now to section 191 of Fig. 1C, the inner gate spacer 135 are above and below the near-tip region 182b2 of the end region 182b. The drain region 108 clads the tip region 182b1 of the end region 182b on multiple sides. For example, the drain region 108 wraps around the tip region 182b1. As illustrated, the drain region 108 is present on five sides of the tip region 182b1 of the nanoribbon 118. For example, the drain region 108 is present on front, back, top, bottom, right one side of the tip region 182b1, while the left side of the tip region 182b1 is conjoined to the near-tip region 182b2. Thus, the tip region 182b1 of the nanoribbon 118 extends within the drain region 108.

Referring to Fig. 1B, the drain region 108 is vertically between a tip region of a nanoribbon 118a and another tip region of another nanoribbon 118b. Thus, an imaginary vertical line passes through various sections of the drain region 108 and the tip regions of multiple (such as all) the nanoribbons 118.

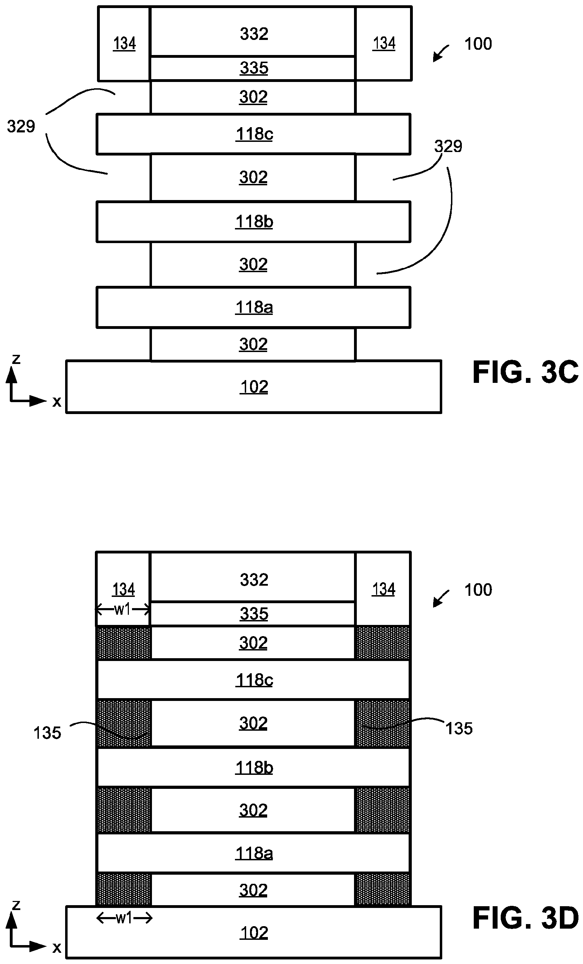

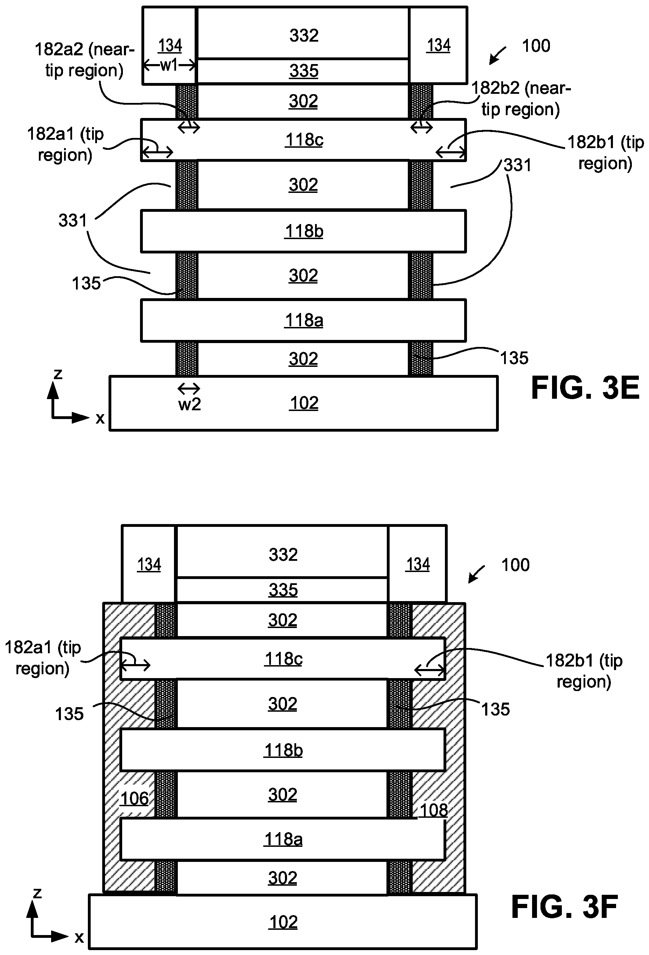

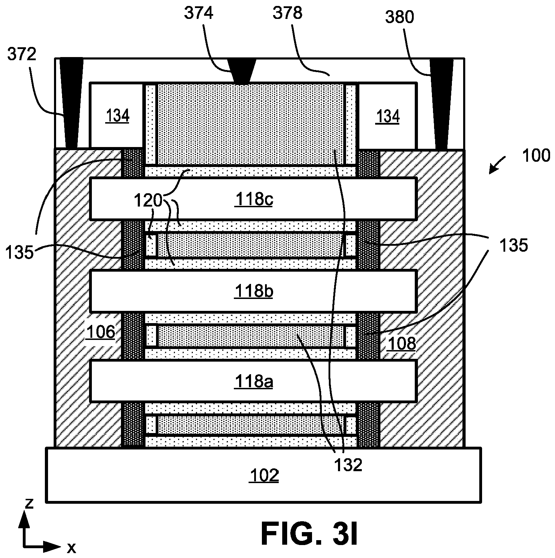

Referring to Fig. 1B, the gate spacers 134 have a width w1, and the inner gate spacers 135 have a width w2. As illustrated in Fig. 1B, the widths are measured in a direction that is parallel to a length of the nanoribbons 118. As seen, the width w1 is more than the width w2 by, for example, at least 5%, or 10%, or 20%. As seen in Fig. 3D, initially both the gate spacers 134 and the inner gate spacers 135 have the width of w1. However, as seen in Fig. 3E, the inner gate spacers 135 are recessed to reduce its width, such that the recessed inner gate spacers 135 has a width of w2 that is less than the width w1 of the gate spacers 134.

In one embodiment, the cladding of the tip regions of the nanoribbons 118 by the source region 106 and the drain region 108 on multiple sides results in enhances strain in the nanoribbons 118. Furthermore, strain in the nanoribbons improves or aids in carrier mobility within the nanoribbons 118, thereby improving the performance of the device 100. In an example, the cladding of the tip regions of the nanoribbons 118 by the source and drain regions on multiple sides provides better control of the nanoribbon channel region by the source and drain regions. The epitaxial growth of the source and drain regions on multiple sides of the nanoribbon tip regions enhances process-induced strain on the nanoribbons 118. For example, the source and drain regions provide uniaxial strain on the nanoribbons 118, due to the above discussed cladding, which in turn improves performance of the device 100.

Referring to Fig. 1D, illustrated is the section 191 of Fig. 1C. In the example of Fig. 1D, seams or grain boundaries 193 are formed between various sections of the drain region 108. Although not illustrated, similar seams or grain boundaries may also be formed between various sections of the source region 106. Thus, discussions of the seams 193 of the drain region 108 with respect to Fig. 1D are also applicable to corresponding seams in the source region 106.

As seen, there are horizontal sections 108aa of the drain region 108 that are adjacent to the tip region of the nanoribbon 118a, and a vertical section 108ba of the drain region 108 that is adjacent to the tip region of the nanoribbon 118a. Thus, two horizontal sections 108aa and one vertical section 108ba of the drain region 108 clads a tip region of the nanoribbon 118a. Similarly, there are two horizontal sections 108ab of the drain region 108 that are adjacent to the tip region of the nanoribbon 118b, and a vertical section 108bb of the drain region 108 that is adjacent to the tip region of the nanoribbon 118b.

In an example, grain boundary or seams 193 may be formed between adjacent sections of the drain region 108. For example, the drain region 108 is formed epitaxially, using the tip regions of the nanoribbons 118 as seed. Thus, for example, horizontal sections 108ab are formed from top and bottom portion of the tip region of the nanoribbon 108b, and vertical sections 108bb is formed from side portion of the tip region of the nanoribbon 108b. Similarly, horizontal sections 108aa are formed from top and bottom portion of the tip region of the nanoribbon 108a, and vertical sections 108ba is formed from side portion of the tip region of the nanoribbon 108a. In an example, due to possible slight misalignment in the various sections of the drain region 108 during the epitaxial growth of the drain region 108, the seams 193 may form. However, in another example, such misalignment may be at least in part absent, which may result in corresponding absence of one or more of the seams 193 of Fig. 1D.

In one embodiment, the base 102 and/or the nanoribbons 118 may have a crystalline orientation described by a Miller index of (100). Accordingly, in an example, the horizontal sections 108aa, 108ab of the drain region 108 (and horizontal sections of the source region 106) may also have a crystalline orientation described by a Miller index of (100). In an example, the vertical sections 108ba, 108bb of the drain region 108 (and vertical sections of the source region 106) may have a crystalline orientation described by a Miller index of either (100) or (110).

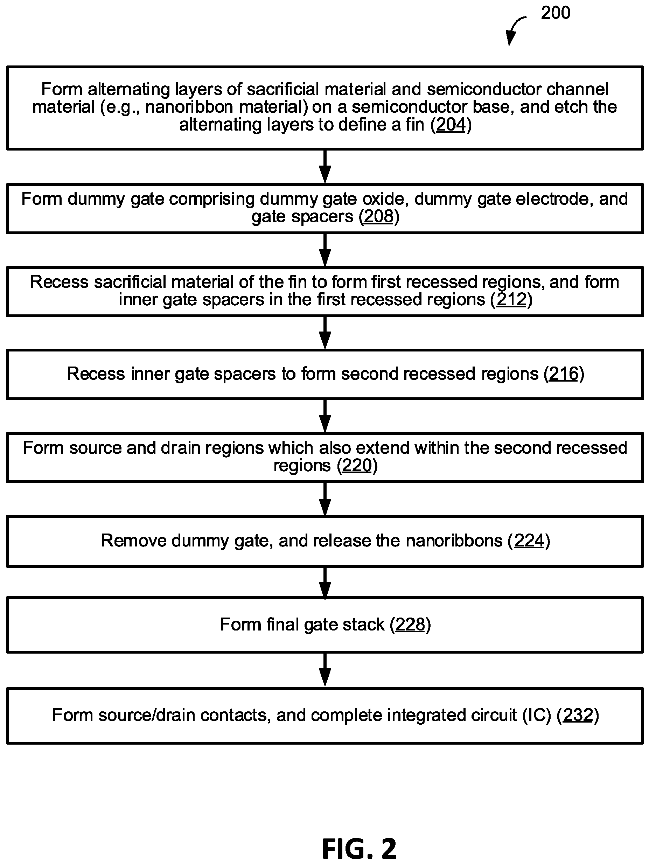

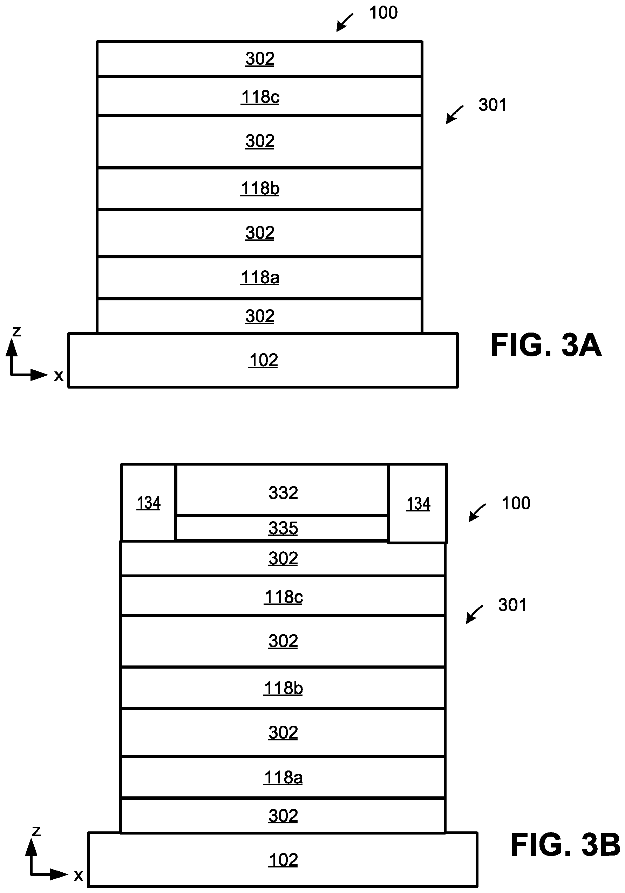

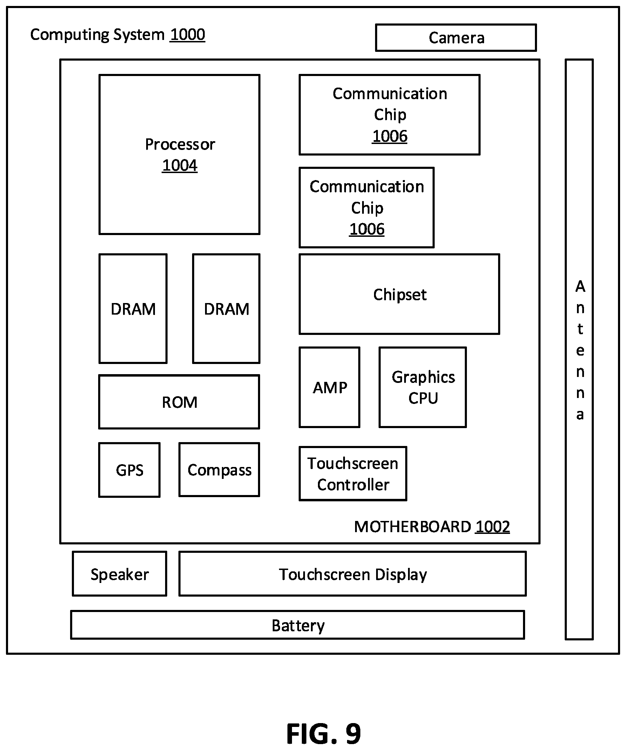

Fig. 2 illustrates a flowchart depicting a method 200 of forming the example non-planar device 100 of Figs. 1A-1D, in accordance with an embodiment of the present disclosure. Figs. 3A-31 illustrate cross-sectional views of an example non-planar device (e.g., the non-planar device 100 of Figs. 1A-1D) in various stages of processing, in accordance with an embodiment of the present disclosure. Figs. 2 and 3A-3I will be discussed in unison.

Referring to Fig. 2, the method 200 includes, at 204, forming alternating layers of sacrificial material and semiconductor channel material (e.g., nanoribbon material) on a semiconductor base, and etching the alternating layers to define a fin. For example, Fig. 3A illustrates a fin 301 formed by the process 204. Fin 301 comprises a stack of alternating material layers on top of the substrate 102, where the stack of alternating material layers includes layers of sacrificial material 302 (e.g., SiGe) and semiconductor channel body (e.g., nanoribbon) material 118 (e.g., Si).

The fin 301 can result from an anisotropic etch through blanket layers of sacrificial material 302 and channel material of the nanoribbons 118 to define the fin 301. Although not illustrated, in an example, the sidewalls of the fin 301 may taper slightly vertically upwards, and the top layer can have a rounded profile due to the etch process, as will be appreciated.

In an example, the base 102 may include any suitable material, such as monocrystalline semiconductor material that includes at least one of silicon (Si), germanium (Ge), carbon (C), tin (Sn), phosphorous (P), boron (B), arsenic (As), antimony (Sb), indium (In), and gallium (Ga) to name a few examples. In some embodiments, the base is bulk silicon, such as monocrystalline silicon. In other embodiments, the base can be any suitable semiconductor material, including silicon, silicon carbide (SiC), gallium nitride (GaN), and gallium arsenide (GaAs) to name a few examples. The base can be selected in some embodiments from III-V materials and group IV materials. Further, the base can comprise a semiconductor layer deposited or grown on a substrate, such as silicon carbide layer epitaxially grown on a sapphire substrate. In still other embodiments, the base can be bulk semiconductor material, such as a wafer sliced from a boule or other bulk semiconductor material.

The base in some embodiments may include a Si on insulator (SOI) structure where an insulator/dielectric material (e.g., an oxide material, such as silicon dioxide) is sandwiched between two Si layers (e.g., in a buried oxide (BOX) structure), or any other suitable starting substrate where the top layer includes Si. In some embodiments, the base may be doped with any suitable n-type and/or p-type dopant at a dopant concentration in the range of 1E16 to 1E22 atoms per cubic cm, for example. For instance, a silicon base can be p-type doped using a suitable acceptor (e.g., boron) or n-type doped using a suitable donor (e.g., phosphorous, arsenic) with a doping concentration of at least 1E16 atoms per cubic cm. However, in some embodiments, the base may be undoped/intrinsic or relatively minimally doped (such as including a dopant concentration of less than 1E16 atoms per cubic cm), for example. In some embodiments, the base is a silicon substrate consisting essentially of Si. In other embodiments, the base may primarily include Si but may also include other material (e.g., a dopant at a given concentration). Also, note that the base material may include relatively high quality or device-quality monocrystalline Si or other material that provides a suitable template or seeding surface from which other monocrystalline semiconductor material features and layers can be formed. Therefore, unless otherwise explicitly stated, a base as described herein is not intended to be limited to a base that only includes Si.

In some embodiments, the base may have a crystalline orientation described by a Miller index of (100), (110), or (111), or its equivalents, as will be apparent in light of this disclosure. Although the base in this example embodiment is shown for ease of illustration as having a thickness (dimension in the Y-axis direction) similar to that of other layers in the figures, the base may be relatively much thicker than the other layers, such as having a thickness in the range of 1 to 950 microns (or in the sub-range of 20 to 800 microns), for example, or any other suitable thickness or range of thicknesses as will be apparent in light of this disclosure. In some embodiments, the base may include a multilayer structure including two or more distinct layers that may or may not be compositionally different. In some embodiments, the base may include grading (e.g., increasing and/or decreasing) of one or more material concentrations throughout at least a portion of the material. In some embodiments, the base may be used for one or more other IC devices, such as various diodes (e.g., light-emitting diodes (LEDs) or laser diodes), various transistors (e.g., MOSFETs or TFETs), various capacitors (e.g., MOSCAPs), various microelectromechanical systems (MEMS), various nanoelectromechanical systems (NEMS), various radio frequency (RF) devices, various sensors, or any other suitable semiconductor or IC devices, depending on the end use or target application. Accordingly, in some embodiments, the structures described herein may be included in a system-on-chip (SoC) application, as will be apparent in light of this disclosure.

As discussed, the process 204 includes forming alternating layers of sacrificial material and channel material on the base 102. In an example, the sacrificial layer is formed directly on the base, followed by the channel material, and followed by additional layer pairs of sacrificial material and channel material, and finally followed by a top layer of sacrificial material. For example, the first (bottom) layer on the base is the sacrificial material and the last (top) layer is also the sacrificial material, thereby providing layers of the channel material between layers of the sacrificial material. In one example embodiment, the base is bulk silicon (Si), the sacrificial material is silicon germanium (SiGe), and the channel material is silicon doped with a suitable dopant and concentration. In another example, the base is graphene, the sacrificial material is gallium, and the channel material is gallium arsenide (GaAs). Other material combinations can also be used, as will be appreciated.

Each layer of sacrificial material or channel material can be formed using any suitable processing, such as one or more deposition or epitaxial growth processes, as will be apparent in light of this disclosure. In one embodiment, alternating layers of sacrificial material and channel material can be formed using layer-by-layer epitaxial growth, where the sacrificial material can subsequently be removed to release nanoribbons of the channel material. For instance, in an example embodiment, a given channel layer may include alternating layers of group IV and group III-V semiconductor material, where either the group IV or group III-V material is sacrificial, to enable the formation of one or more nanoribbons. In some embodiments, a given layer of channel material may include a vertical channel height (dimension in the Y-axis direction) in the range of 5nm to 50 nm (or in a subrange of 5-45, 5-40, 5-35. 5-30. 5-25, 5-20, 5-15, 5-10, 10-40, 10-30, 10-20, 15-40, 15-30, 15-20, 20-40, 20-30 and 30-40 nm) and/or a maximum vertical thickness of at most 50, 40, 30, 25, 20, 15, or 10 nm, for example. Other suitable materials and channel height requirements or thresholds will be apparent in light of this disclosure.

In some embodiments, multiple different channel materials may be formed on different areas of the substrate, such as for CMOS applications, for example. For instance, a first channel material may be formed on a first area of the substrate to be used for one or more p-channel transistor devices (e.g., one or more PMOS devices) and a second channel material may be formed on a second area of the substrate 200 to be used for one or more n-channel transistor devices (e.g., one or more NMOS devices). By selecting the subfin material to have the desired properties, multiple different channel materials can be grown. For instance, in some such embodiments, the first channel material may include a n-type group III-V or group IV material and a second channel material may include a p-type group III-V or group IV material.

In some embodiments employing multiple different channel materials, the first channel material may include group IV semiconductor material (e.g., Si, SiGe, Ge, etc.) and the second channel material may include group III-V semiconductor material (e.g., GaAs, InGaAs, InP, etc.). In general, a given channel material may include monocrystalline group IV semiconductor material and/or group III-V semiconductor material. For instance, in a beaded-fin transistor configuration, the channel region may include both group IV semiconductor material (e.g., for the broader or narrower portions) and group III-V semiconductor material (e.g., for the other of the broader or narrower portions). Note that the multiple different channel materials may be formed using any suitable techniques, such as masking, depositing, and removing the masking as desired to form any number of compositionally different channel materials. Numerous different channel material configurations and variations will be apparent in light of this disclosure.

As discussed, the process 204 further includes defining the fin 301. For example, the fin 301 has a subfin portion (e.g., subfin portion 110, see Fig. 1A) of base material and an upper fin portion of alternating layers of sacrificial material and channel material. In embodiments where blanket layers of material are formed on the base, for example, regions to be processed into fins are masked, followed by etching the surrounding regions to define one or more fins. For instance, an anisotropic etch proceeds substantially vertically through the upper fin portion to define isolation trenches between adjacent fins. In some embodiments, the etch process proceeds into the base to define a fin that includes a subfin portion of the base material and an upper fin portion of alternating layers of sacrificial material and channel material. In some embodiments, the etch process defines groups of parallel fins extending vertically up from the base. In other embodiments, the etch defines planar or 3D transistor structures having an H shape, where the channel region corresponds to the beam extending between the source and drain regions represented by the vertical bars of the H.

In other embodiments, for example, the alternating layers of sacrificial material and channel material are formed on the base by growth or deposition in a trench. For example, the trench is an aspect ratio trapping trench ("ART" trench) defined in a layer of insulating material, such as silicon dioxide (SiO₂) formed by thermal oxidation or by deposition using a suitable one of the aforementioned techniques. The insulating material is then patterned and etched to define trenches that extend to a substrate or other material layer. A base material can be formed directly on the substrate in the lower portion of the trench, followed by alternating layers of the sacrificial material and channel material. The insulating material can be recessed to expose all or part of the fin. In some embodiments, the insulating material is recessed to the top of the subfin (i.e., base material) to expose only the layer stack of sacrificial material and channel material in the upper portion of the fin. In other embodiments, the insulating material is recessed completely to expose the entire subfin, or recessed to a level below the first layer of sacrificial material to expose a portion of the subfin. Numerous variations and embodiments will be apparent in light of the present disclosure.

In yet other embodiments, defining fins may be performed using a replacement fin-based approach. In one embodiment, the replacement fin-based approach includes forming fins in the base, such as by patterning and etching bulk semiconductor material. Shallow trench isolation (STI) material is the formed around those fins, followed by recessing the native-to-substrate fins to define fin-shaped trenches in the STI material. Subfin material and alternating layers of sacrificial material and channel material can then be formed in the fin-shaped trenches. In one embodiment, the replacement fin approach continues with removing the STI material and forming an insulating material on the base between the subfins, leaving the layer stack of alternating sacrificial material and channel material exposed.

In some embodiments, the subfin is a Group IV semiconductor material, such as single-crystal silicon or germanium. In other embodiments, the subfin material is a Group III-V semiconductor material, such as GaAs, InGaAs, AlGaAs, or AlAs, to name a few examples. In some embodiments, the subfin material may or may not be doped with a suitable dopant (e.g., boron, phosphorous, and/or arsenic). In embodiments where the subfin material is doped, it may be n-type doped (e.g., with phosphorous or arsenic) or p-type doped (e.g., with boron) at a dopant concentration in the range of 1E16 to 1E22 atoms per cubic cm, for example. In some embodiments, the subfins may have a multilayer structure including two or more distinct layers (that may or may not be compositionally different). In some embodiments, the subfins may include grading (e.g., increasing and/or decreasing) of one or more material concentrations throughout at least a portion of the subfin material.

In some embodiments, each fin may include a vertical fin height (dimension in the Y-axis direction) in the range of 20-500 nm (or in a subrange of 20-50, 20-100, 20-200, 20-300, 20-400, 50-100, 50-200, 50-300, 50-400, 50-500, 100-250, 100-400, 100-500, 200-400, or 200-500 nm) and/or a maximum vertical fin height of at most 500, 450, 400, 350, 300, 250, 200, 150, 100, or 50 nm, for example. In some embodiments, each fin may include a horizontal fin width (dimension in the X-axis direction) in the range of 2-50 nm (or in a subrange of 2-5, 2-10, 5-10, 5-20, 5-30, 5-50, 10-20, 10-30, 10-50, 20-30, 20-50, or 30-50 nm) and/or a maximum horizontal fin width of at most 50, 30, 20, 10, or 5 nm, for example. In some embodiments, the ratio of fin height to fin width may be greater than 1, such as greater than 1.5, 2, 2.5, 3, 3.5, 4, 4.5, 5, 6, 7, 8, 9, 10, 15, 20, or greater than any other suitable threshold ratio, as will be apparent in light of this disclosure. Other suitable materials and thickness values/ranges/thresholds will be apparent in light of this disclosure.

In some embodiments, the base or subfin material may be oppositely type doped relative to the overlying upper fin material (e.g., of the source and drain regions) to provide a tunnel diode configuration to help reduce or eliminate parasitic leakage (e.g., subthreshold leakage). For instance, in some embodiments, the subfin material may be intentionally p-type doped (e.g., with a doping concentration of at least 1E16, 5E16, 1E17, 5E17, 1E18, 5E18, or 1E19 atoms per cubic cm) if the overlying material is to be n-type doped, or vice versa.

Referring again to Fig. 2, the method 200 then proceeds from 204 to 208, which includes forming dummy gate on channel regions of the fins, where the dummy gate comprises dummy gate oxide, dummy gate electrode, and gate spaces, as illustrated in Fig. 3B. In one embodiment, forming the dummy gate may include deposition of a dummy gate oxide 335, deposition of a dummy gate electrode 332 (e.g., poly-Si), and optionally, deposition and patterning of a hardmask. Gate spacers 134 are formed along opposite sides of the dummy gate electrode 332. For example, the gate spacers 134 comprise silicon nitride (Si3N4) or other suitable material, as will be appreciated.

Referring again to Fig. 2, the method 200 then proceeds from 208 to 212, where the sacrificial material of the fin is recessed to form first recessed regions, and inner gate spacers are formed in the first recessed regions. For example, as illustrated in Fig. 3C, the sacrificial material 302 of the fin 301 is recessed on both sides to form first recessed regions 329, via a suitable etch process that is selective to the nanoribbons 118. For example, the sacrificial material 302 is etched, without the nanoribbons 118 or the gate spacers 134 being etched. For example, a wet etch (e.g., nitric acid/hydrofluoric acid), an anisotropic dry etch, or other suitable etch process may be used, as will be appreciated. Subsequently, the inner gate spacers 135 are formed in the recessed regions 329, as illustrated in Fig. 3D. The inner gate spacers 135 are formed using any suitable deposition technique, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example.

Referring again to Fig. 2, the method 200 then proceeds from 212 to 216, where the inner gate spacers are recessed, to form second recessed regions. For example, Fig. 3E illustrates the inner gate spacers 135 after being recessed, to form second recessed regions 331. For example, a wet etch (e.g., nitric acid/hydrofluoric acid), an anisotropic dry etch, or other suitable etch process may be used for recessing the inner gate spacers 135, as will be appreciated.

Recessing the inner gate spacers 135 frees the tip regions 182a1, 182b1 of the nanoribbons 118 (i.e., the tip regions 182a1, 182b1 are no longer covered by the inner gate spacers 135). The near-tip regions 182a2, 182b2 are still covered by the inner gate spacers 135.

As seen in Fig. 3E, the gate spacers 134 have a width w1, and the inner gate spacers 135 have a width w2. As illustrated, the widths are measured in a direction that is parallel to a length of the nanoribbons 118. As seen, the width w1 is more than the width w2 by, for example, at least 5%, or at least 10%, or at least 20%. As seen in Fig. 3D, initially both the gate spacers 134 and the inner gate spacers 135 have the width of w1. However, as seen in Fig. 3E, the inner gate spacers 135 are recessed to reduce its width, such that each of the recessed inner gate spacers 135 have a width of w2 that is less than the width w1 of each of the gate spacers 134.

Referring again to Fig. 2, the method 200 then proceeds from 216 to 220, where source and drain regions are formed, where the source and drain regions also extend within the second recessed regions. Fig. 3F illustrates the source region 106 and drain region 108, where sections of the source region 106 and drain region 108 are within the recesses 331 of Fig. 3E. In one embodiment, the epitaxially formed source and drain regions 106, 108 clads the tip regions 182a1, 182b1 of the nanoribbons 118 on multiple sides, as illustrated in Fig. 3F and as also discussed with respect to Figs. 1B-1D.

In one embodiment, forming the source and drain regions can be performed by etching at least a portion of the exposed source and drain portion of the fins to remove the layer stack, and forming replacement source and drain material using any suitable techniques, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example. In some embodiments, the exposed source/drain regions of the fins need not be completely removed; instead, the material in the layer stack at the source/drain regions is converted to final source/drain regions by doping, implantation, and/or cladding with a source/drain material or other suitable processing, for example.

In some embodiments, the source and drain regions may be formed one polarity at a time, such as performing processing for one of n-type and p-type regions, and then performing processing for the other of the n-type and p-type regions. In some embodiments, the source and drain regions may include any suitable doping scheme, such as including suitable n-type and/or p-type dopant (e.g., in a concentration in the range of 1E16 to 1E22 atoms per cubic cm). However, in some embodiments, at least one source or drain region may be undoped/intrinsic or relatively minimally doped, such as including a dopant concentration of less than 1E16 atoms per cubic cm, for example.

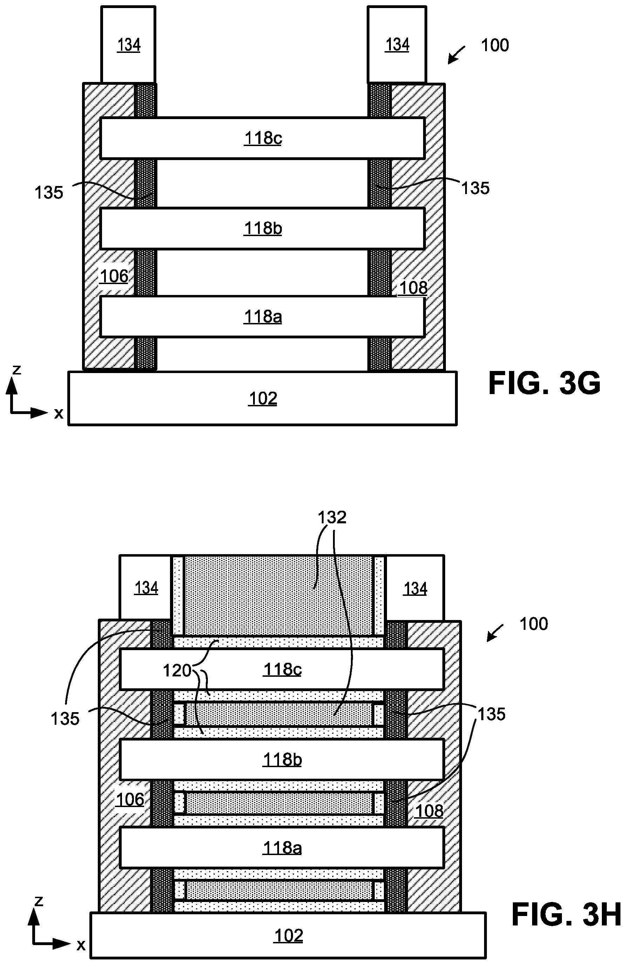

Referring again to Fig. 2, the method 200 then proceeds from 220 to 224, which comprises removing the dummy gate, and releasing nanoribbons in the channel region. Fig. 3G illustrates the device 100, with the dummy gate oxide 335 and dummy gate electrode 332 removed, and the nanoribbons 118 released by removing the sacrificial material 302.

Note that, prior to releasing the nanoribbons, the dummy gate materials are removed via an etch process that is selective to the gate spacers 134 and inner gate spacers 135 and other non-gate materials exposed during channel and gate processing. Removing the dummy gate electrode between the gate spacers exposes the channel region of the fin. For example, a polycrystalline silicon dummy gate electrode can be removed using a wet etch process (e.g., nitric acid/hydrofluoric acid), an anisotropic dry etch, or other suitable etch process, as will be appreciated. At this stage of processing, the layer stack of alternating layers of channel material and sacrificial material is exposed in the channel region. The channel region extends between and contacts the source and drain regions, where ends of the layer stack in the are protected by the inner gate spacers 135.

The sacrificial material 302 in the layer stack can then be removed by etch processing, to release the nanoribbons 118, in accordance with some embodiments. Etching the sacrificial material 302 may be performed using any suitable wet or dry etching process such that the etch process selectively removes the sacrificial material and leaves intact the channel material. In one embodiment, the sacrificial material is silicon germanium (SiGe) and the channel material is electronic grade silicon (Si). For example, a gas-phase etch using an oxidizer and hydrofluoric acid (HF) has shown to selectively etch SiGe in SiGe/Si layer stacks. In another embodiment, a gas-phase chlorine trifluoride (ClF3) etch is used to remove the sacrificial SiGe material. The etch chemistry can be selected based on the germanium concentration, nanoribbon dimensions, and other factors, as will be appreciated. After removing the SiGe sacrificial material, the resulting channel region includes silicon nanoribbons extending between the source and drain regions of the fin, where ends of the nanoribbons (e.g., silicon) contact the source and drain structures and remain at least partially protected by the gate spacers.

Referring again to Fig. 2, the method 200 then proceeds from 224 to 228, which comprises forming a final gate stack. For example, Fig. 3H illustrates the device 100, with the corresponding gate stack formed. For example, the gate stack of the device 100 comprises gate dielectric 120 wrapped around middle regions of individual nanoribbons 118, and the gate electrode 132 around the gate dielectric 120.

In this example embodiment, the gate stack is formed using a gate-last fabrication flow, which may be considered a replacement gate or replacement metal gate (RMG) process. In embodiments utilizing a nanoribbon channel structure, the gate stack may substantially (or completely) surround each nanoribbon middle region portion, such as wrapping around at least 80, 85, 90, 95% or more of each nanoribbon. Processing the final gate stack includes depositing the gate dielectric 120 on the exposed nanoribbon middle region in the channel region, followed by formation of the gate electrode 132 in contact with the gate dielectric. Any suitable technique can be used, including spin-coating or CVD deposition, for example. The gate dielectric 120 may include, for example, any suitable oxide (such as silicon dioxide), high-k dielectric material, and/or any other suitable material as will be apparent in light of this disclosure. Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. In some embodiments, the gate dielectric 120 can be annealed to improve its quality when high-k dielectric material is used. The gate electrode 132 may include a wide range of materials, such as polysilicon or various suitable metals or metal alloys, such as aluminum (Al), tungsten (W), titanium (Ti), tantalum (Ta), copper (Cu), titanium nitride (TiN), or tantalum nitride (TaN), for example.

In some embodiments, gate dielectric and/or gate electrode may include a multilayer structure of two or more material layers, for example. For instance, in some embodiments, a multilayer gate dielectric may be employed to provide a more gradual electric transition from the channel region to the gate electrode, for example. In some embodiments, the gate dielectric and/or gate electrode may include grading (e.g., increasing and/or decreasing) the content or concentration of one or more materials in at least a portion of the feature(s). In some embodiments, one or more additional layers may also be present in the final gate stack, such as one or more relatively high or low work function layers and/or other suitable layers. Note that the gate dielectric may also be used to form replacement gate spacers on one or both sides of the nanoribbon body, such that the gate dielectric is between the gate electrode and one or both gate spacers, for example. Numerous different gate stack configurations will be apparent in light of this disclosure.

Referring again to Fig. 2, the method 200 then proceeds from 228 to 232, which comprises forming corresponding source/drain contacts, and completing the integrated circuit (IC). Fig. 31 illustrates the device 100, with corresponding source/drain contacts formed. For example, Fig. 31 illustrates conductive source contact 372 extending through an ILD 378 and contacting the source region 106, conductive drain contact 380 extending through the ILD 378 and contacting the drain region 108, and conductive gate contact 374 extending through the ILD 378 and contacting the gate electrode 132.

In some embodiments, the source and drain contacts can be formed using any suitable techniques, such as forming contact trenches in the ILD layer 378 over the respective source/drain regions, and then depositing metal or metal alloy (or other suitable electrically conductive material) in the trenches. In some embodiments, forming the source/drain contacts may include silicidation, germanidation, III-V-idation, and/or annealing processes, for example. In some embodiments, the source and drain contacts may include aluminum or tungsten, although any suitable conductive metal or alloy can be used, such as silver, nickel-platinum, or nickel-aluminum, for example. In some embodiments, one or more of the source and drain contacts may include a resistance reducing metal and a contact plug metal, or just a contact plug, for instance. Example contact resistance reducing metals include, for instance, nickel, aluminum, titanium, gold, gold-germanium, nickel-platinum, nickel aluminum, and/or other such resistance reducing metals or alloys. Example contact plug metals include, for instance, aluminum, copper, nickel, platinum, titanium, or tungsten, or alloys thereof, although any suitably conductive contact metal or alloy may be used. In some embodiments, additional layers may be present in the source and drain contact regions, such as adhesion layers (e.g., titanium nitride) and/or liner or barrier layers (e.g., tantalum nitride), if so desired. In some embodiments, a contact resistance reducing layer may be present between a given source or drain region and its corresponding source or drain contact, such as a relatively highly doped (e.g., with dopant concentrations greater than 1E18, 1E19, 1E20, 1E21, or 1E22 atoms per cubic cm) intervening semiconductor material layer, for example. In some such embodiments, the contact resistance reducing layer may include semiconductor material and/or impurity dopants based on the included material and/or dopant concentration of the corresponding source or drain region, for example.

Referring again to Fig. 2, the process 232 also includes completing a general IC comprising the device 100, as desired, in accordance with some embodiments. Such additional processing to complete an IC may include back-end or back-end-of-line (BEOL) processing to form one or more metallization layers and/or to interconnect the transistor devices formed, for example. Any other suitable processing may be performed, as will be apparent in light of this disclosure.

Note that the processes in method 200 are shown in a particular order for ease of description. However, one or more of the processes may be performed in a different order or may not be performed at all (and thus be optional), in accordance with some embodiments. Numerous variations on method 200 and the techniques described herein will be apparent in light of this disclosure.

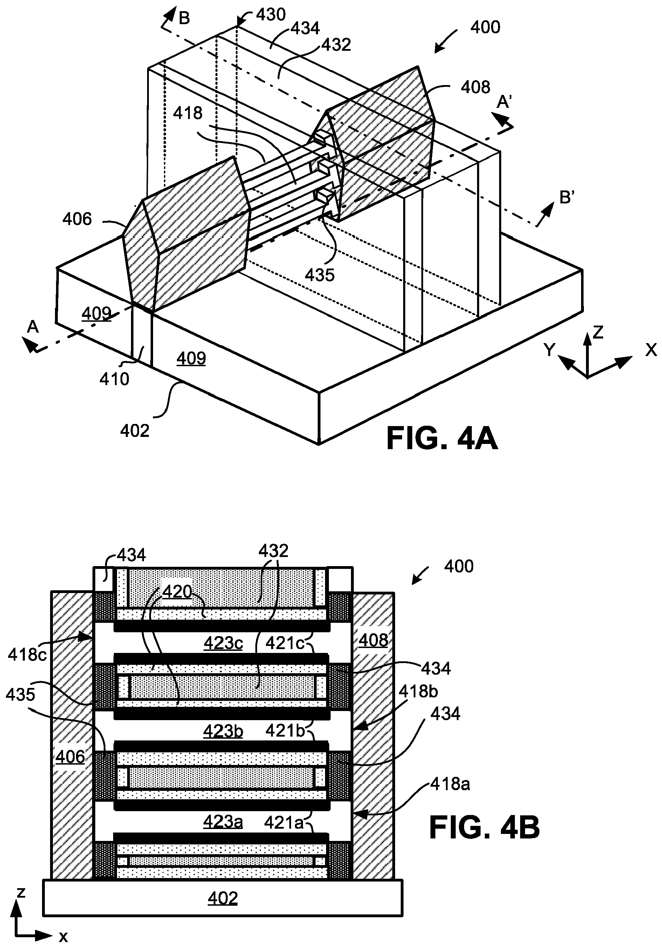

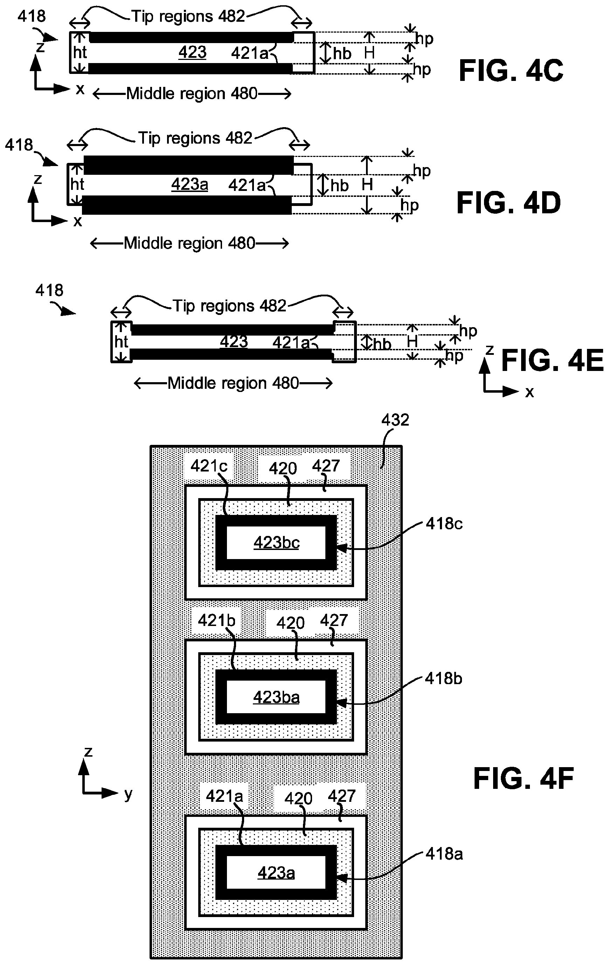

Fig. 4A illustrates perspective view of a non-planar device 400, where individual channel body 418 of the non-planar device 400 comprises a core structure 423 and a peripheral structure 421 at least in part wrapped around the core structure 423, in accordance with an embodiment of the present disclosure. Fig. 4B illustrates a cross-sectional view of the non-planar device 400 of Fig. 4A, in accordance with an embodiment of the present disclosure. Figs. 4C, 4D, and 4E illustrate different implementations of a channel body 418 of the non-planar device 400 of Figs. 4A-4B in further detail, in accordance with an embodiment of the present disclosure. Fig. 4F illustrates another cross-sectional view of the non-planar device 400 of Fig. 4A, in accordance with an embodiment of the present disclosure.

The cross-sectional views of the non-planar device 400 (also referred to herein as "device 400") of Figs. 4B, 4C, 4D, and 4E are along line A-A' of Fig. 4A, which is the so called "fin cut" or "channel cut" view of the device 400. The cross-sectional view of the non-planar device 400 of Fig. 4F is along line B-B' of Fig. 1A, which is the so called "gate cut" view of the device 400.

In some examples, the non-planar device 400 is a GAA device, such as a GAA transistor. Although some embodiments of this disclosure have been discussed with respect to a nanoribbon GAA transistor, the teachings of this disclosure can also be employed in other types of GAA or non-planar transistors as well, such as nanowire transistors, nanosheet transistors, or forksheet transistors, as will be appreciated in light of this disclosure.

Note that the perspective view of Fig. 4A does not illustrate inner gate spacers 435 (although label 435 in Fig. 4A points to a location of the inner gate spacers 435), and also does not illustrate peripheral layers 421 of various nanoribbons 418. These features are illustrated in Figs. 1B-1E. Furthermore, the gate electrode 432 and the gate spacers 434 are illustrated to be transparent in Fig. 4A, in order to show the nanoribbons 418 extending through the gate electrodes and gate spacers. Thus, Fig. 4A introduces the overall three-dimensional (3D) non-planar structure of the device 400, while Figs. 4B-4F illustrate the features discussed herein in further detail.

As can be seen, the device 400 is formed on a substrate 402. The device 400 includes a subfin region 410, above which the nanoribbons 418 of the device 400 are vertically stacked. As illustrated, the device 400 may be separated from any adjacent device (not illustrated) by a dielectric fill 409. The substrate 402, subfin region 410, and dielectric fill 409 have been discussed in detail with respect to the device 100 of Figs. 1A-1D (e.g., correspond to the substrate 102, subfin region 110, and dielectric fill 109, respectively, of Figs. 1A-1D).

The device 400 includes a channel region laterally extending between and connecting source region 406 and drain region 408. The channel region includes two or more channel bodies 418, such as nanoribbons 418 (e.g., nanoribbons 418a, 418b, 418c), that extend horizontally and are arranged in a vertical stack. According to some embodiments, the source region 406 and drain region 408 are epitaxial regions that are provided using an etch-and-replace process. In other embodiments, one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. Any semiconductor materials suitable for source and drain regions can be used (e.g., group IV and group III-V semiconductor materials). In an example, the source and drain regions may be appropriately doped, based on a type of device (e.g., PMOS or NMOS).

The device 400 includes channel bodies 418, such as nanoribbons 418a, 418b, 418c, generally referred to as nanoribbons 418. Although the device 400 is illustrated to include three nanoribbons, the channel region of the device 400 can have any different number of nanoribbons, such as one, two, four, or higher. Although the nanoribbons 418 extend horizontally and are stacked vertically in device 400, the present disclosure contemplates nanoribbons in a variety of configurations that include planar nanoribbon transistors, nanoribbons that extend vertically and are stacked horizontally, and other arrangements, as will be appreciated. In an example, the nanoribbons 418 comprise an appropriately doped semiconductor material, such as appropriately doped silicon.

In the device 400, a gate structure 430 contacts and at least in part surrounds each nanoribbon 418 between the source and drain regions 406, 408, where the gate structure 430 includes gate dielectric 420, a gate electrode 432, gate spacers 434, and inner gate spacers 435.

Fig. 4C illustrates a single nanoribbon 418. As seen, the nanoribbon 418 (and other nanoribbons as well of the device 100) comprise a middle region 480 between tip regions 482. For example, the tip regions 482 of individual nanoribbons 418 are in contact with the source region 406 and the drain region 408.

The dielectric layer 420 wraps around the middle region 480 of individual nanoribbons 418, but doesn't wrap around the tip regions 482a of individual nanoribbons 418.

In an example, the gate dielectric 420 may include a single material layer or multiple stacked material layers. In some embodiments, gate dielectric 420 includes a first dielectric layer such as silicon oxide, and a second dielectric layer that includes a high-K material such as hafnium oxide. The hafnium oxide may be doped with an element to affect the threshold voltage of the given semiconductor device. According to some embodiments, the doping element used in gate dielectric is lanthanum. The gate dielectric 420 is present around middle regions of each nanoribbon 418, and although not illustrated, may also be present over subfin portion 410. In some embodiments and although not illustrated, gate dielectric 420 is also present over a top surface of dielectric fill 409.

In some embodiments and illustrated in Fig. 4F, one or more work function metals 427 may be included around the individual nanoribbons of the device 400. The work function metals 427 are illustrated in Fig. 4F, but not in Figs. 4A-4E for purposes of illustrative clarity. In one example, the work function metals 427 may be absent around one or more nanoribbons (or all nanoribbons) of the device 400.

According to some embodiments, a gate electrode 432 extends over and wraps around the nanoribbons 418. Gate electrode 432 may include any sufficiently conductive material such as a metal, metal alloy, or doped polysilicon.

As seen in Fig. 4B, the gate structure also includes inner gate spacers 435 that is present between the source region 406 and the gate electrode 432, as well as between the drain region 408 and the gate electrode 432. The inner gate spacers 435 isolate the gate electrode 432 from the source and drain regions 406, 408. For example, a first inner gate spacer isolates the gate electrode 432 from the source region 406, and a second inner gate spacer isolates the gate electrode 432 from the drain region 408. In an example, the inner gate spacers 435 and the gate spacers 434 are compositionally same. In another example, the inner gate spacers 435 and the gate spacers 434 are compositionally different.

In one embodiment, the tip regions 482 of a nanoribbon 418 are on two ends of the nanoribbon, and the middle region 423 is laterally between the corresponding two tip regions 482. The tip regions 482 are covered by corresponding inner gate spacers 435. In the example of Figs. 4B and 4C, a first gate spacer 435 that is between the gate electrode 432 and the source region 406 covers tip regions 482 that are on left side of the device 400, and a second gate spacer 435 that is between the gate electrode 432 and the drain region 408 covers tip regions 482 that are on right side of the device 400. As illustrated, the two inner gate spacers 435 extend in a direction that is perpendicular to a direction in which the nanoribbons 418 extend.

In one embodiment and as illustrated in Figs. 4B-4E, individual nanoribbon 418 comprises a base or core structure 423 laterally extending between the source region 106 and the drain region 108, and a peripheral structure 421 wrapping around at least a middle section of the core structure 423. For example, the core structure 423 includes the first and second tip regions 482 and a section of the middle region 480, as illustrated in Figs. 4C-4E. For example, the core structure 423 has a dumb-bell or "H" like shape, where the tip regions 482 form the two vertical end lines of the "H" and a section of the middle region 480 forms the horizontal line of the "H."

The peripheral structure 421 includes another section of the middle region 480. The peripheral structure 421 wraps around the core structure 423 in the middle region 480. Thus, the peripheral structure 421 is in the middle region 480 of a nanoribbon 418, and not in the tip regions 482 of the nanoribbon 418.

In one embodiment and as illustrated in Figs. 4B and 4F, the peripheral structure 421 separates the core structure 423 from the gate dielectric 420. For example, the peripheral structure 421 is between the core structure 423 and the gate dielectric 420.

Figs. 4C, 4D, and 4E illustrate three different configurations of the core structure 423 and the peripheral structure 421. Referring to Figs. 4C, 4D, and 4E, a vertical height of the tip regions 482 is ht, and a vertical height of the core structure 423 within the middle region 480 is hb. Thus, the core structure 423 has a height of ht in the tip regions 482, and a height of hb in the middle region 480.

A vertical height (or width) of the peripheral structure 421 is hp. Note that the peripheral structure 421 is wrapped around the core structure 423 in the middle region 480, and hence, the peripheral structure 421 has a total vertical height of 2.hp. Thus, a total vertical height of the middle region 480 is H = (2.hp+hb).

In the example of Fig. 4C, H = (2.hp+hb) ≈ ht. Thus, in the example of Fig. 4C, the height ht of the tip regions 482 is similar (e.g., within 10%, or within 5%, or within 2%, or within 1%) of the height H of the middle region 480. Thus, top surfaces of the tip regions 482 and middle region 480 are almost or fully planar or flush, and bottom surfaces of the tip regions 482 and middle region 480 are almost or fully planar or flush.

In the example of Fig. 4D, H = (2.hp+hb) > ht. Thus, in the example of Fig. 4D, a height ht of the tip regions 482 is less than (e.g., at least 10% less, or at least 5% less, or at least 2% less, or at least 1% less) a height H of the middle region 480. Thus, top surfaces of the tip regions 482 is at a lower level than a top surface of the middle region 480, and bottom surfaces of the tip regions 482 is at a higher level than a bottom surface of the middle region 480.

In the example of Fig. 4E, H = (2.hp+hb) < ht. Thus, in the example of Fig. 4E, a height ht of the tip regions 482 is more than (e.g., at least 10% more, or at least 5% more, or at least 2% more, or at least 1% more) a height H of the middle region 480. Thus, top surfaces of the tip regions 482 is at a higher level than a top surface of the middle region 480, and bottom surfaces of the tip regions 482 is at a lower level than a bottom surface of the middle region 480.

In one embodiment, a total height (or total width) of the peripheral structure 421 (i.e., 2.hp) is about 50% of the total height H of the middle region 480. In an example, the total height of the peripheral structure 421 (i.e., 2.hp) is within a range of 40% to 60%, or within a range of 30% to 70%, or within a range of 20% to 80% of the total height H of the middle region 480. Merely as an example, the total height H of the middle region 480 may be 8 nanometers (nm), and height hp of the peripheral structure 421 is in a range of 1 to 3 nm, such that the total height (or total width) of the peripheral structure 421 is in a range of 2 to 6 nm. In a specific example, the total height H of the middle region 480 may be 8 nm, and height hp of the peripheral structure 421 is 2 nm, such that the total height (or total width) of the peripheral structure 421 is 4 nm.

In one embodiment, the peripheral structure 421 is compositionally different from the core structure 423, and the peripheral structure 421 material is selected to impart high mobility to the charge carriers (i.e., holes or electrons). The core structure 423 forms a skeleton of a channel body, and the peripheral structure 421 forms high mobility area of the channel body. In an example, the core structure 423 is under strain, which increases a carrier mobility through the core structure 423. The high mobility peripheral structure 421 further increases carrier mobility. In an example, the cladded peripheral structure 421 increases an overall mobility of the nanoribbon 418, which improves performance of the device 400. For example, a transistor drive strength is dominated by the high mobility cladding of the peripheral structure 421.

The following Table I depicts various choices of materials for the core structure 423 and the peripheral structure 421.

**Table I**

| **Option Number** | **Core structure 423** | **Peripheral structure 421 for PMOS** | **Peripheral structure 421 for NMOS** |
|---|---|---|---|
| 1. | Si (including strained Si) | SiGe | Si (including strained Si) (e.g., no separate peripheral structure needed, as core and peripheral structures have same composition) |
| 2. | SiGeₓ | SiGe_{y} (where y > x) | Si (including strained Si) |
| 3. | Si₍₁₋ₓ₎Geₓ (where x is as high as 100) | Ge | InGaAs |

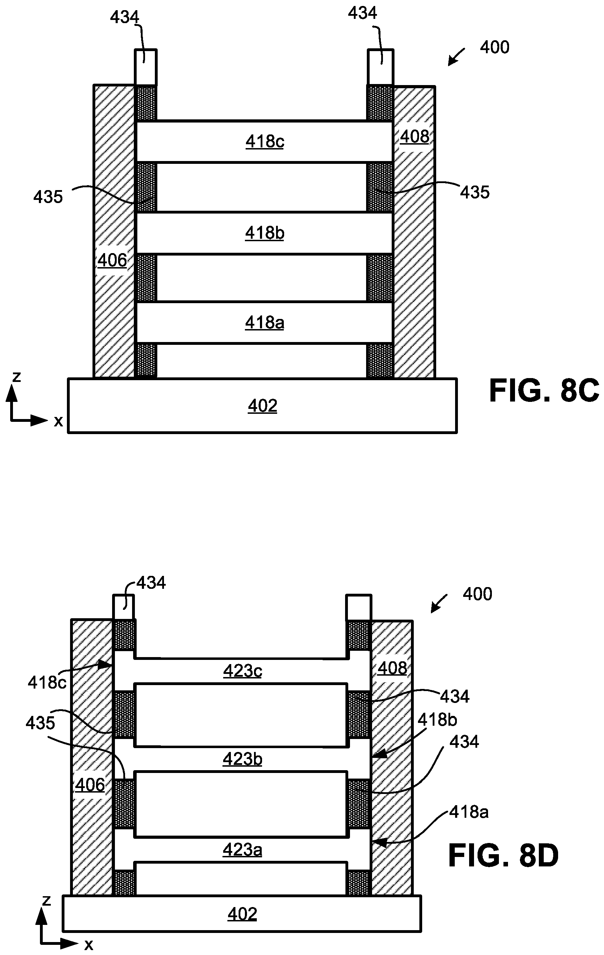

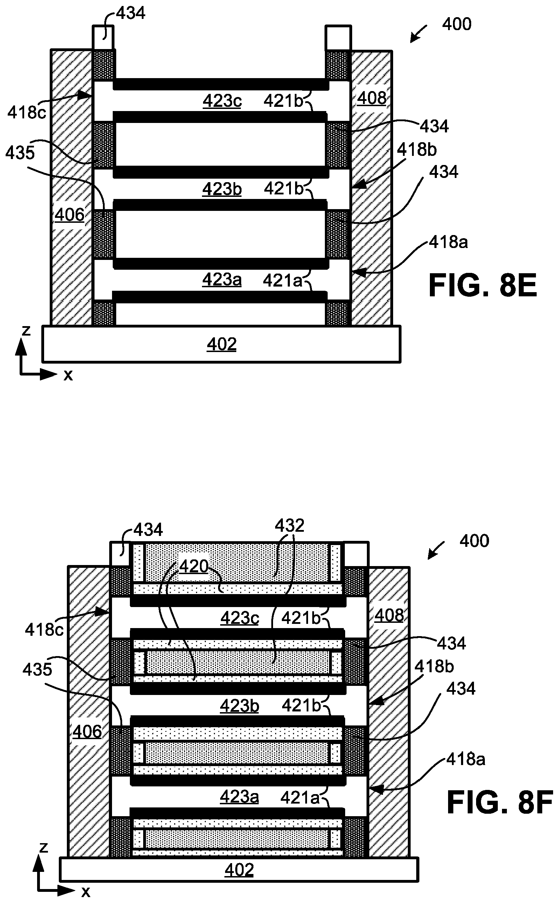

Referring to option 1 of Table 1, in an example, the core structure 423 comprises silicon (Si) and the peripheral structure 421 for a PMOS transistor may comprise silicon germanium (SiGe). Also, for the core structure 423 comprising Si, the peripheral structure 421 for an NMOS transistor may also comprise silicon. Thus, for this option in which the core structure 423 comprises Si, the PMOS transistor may have a peripheral structure 421 of SiGe and the NMOS transistor may not have any separate peripheral structure. For example, the middle region of individual nanoribbons of the PMOS transistor may be thinned, followed by deposition of the peripheral structure 421 (see Figs. 8D and 8E for further detail). However, for the NMOS transistor, this thinning and deposition processes may be skipped for option 1 of the Table 1. In an example, for option 1 of the Table 1, the Si of the core structure 423 and/or the Si of the peripheral structure 421 may be strained.

Referring now to option 2 of Table 1, in an example, the core structure 423 comprises SiGeₓ, and the peripheral structure 421 for a PMOS transistor may comprise SiGe_{y}. In an example, y is different from x. In the example of Table 1, y > x, i.e., Ge concentration in the peripheral structure 421 is higher than Ge concentration in the core structure 423. Also, for the core structure 423 comprising SiGeₓ, the peripheral structure 421 for an NMOS transistor may comprise Si (e.g., strained Si).

Referring now to option 3 of Table 1, in an example, the core structure 423 comprises Si₍₁₋ₓ₎Geₓ, and the peripheral structure 421 for a PMOS transistor may comprise Ge. Note that the "x" in SiGeₓ of the core structure 423 can be as high as 100% or 1, i.e., the core structure can comprise SiGe or solely Ge. Also, for the core structure 423 comprising Si₍₁₋ₓ₎Geₓ, the peripheral structure 421 for an NMOS transistor may comprise indium gallium arsenide (InGaAs).

In general, in an example, the core structure 423 may include group IV semiconductor material (e.g., Si, SiGe, Ge, etc.), and the peripheral structure 421 may include group IV semiconductor material and/or group III-V semiconductor material (e.g., GaAs, InGaAs, InP, etc.).

It may be noted that the various options depicted in Table 1 are examples and are not intended to limit the scope of this disclosure. Materials different from those listed in Table 1 may also be used for the core structure 423 and/or the peripheral structure 421.

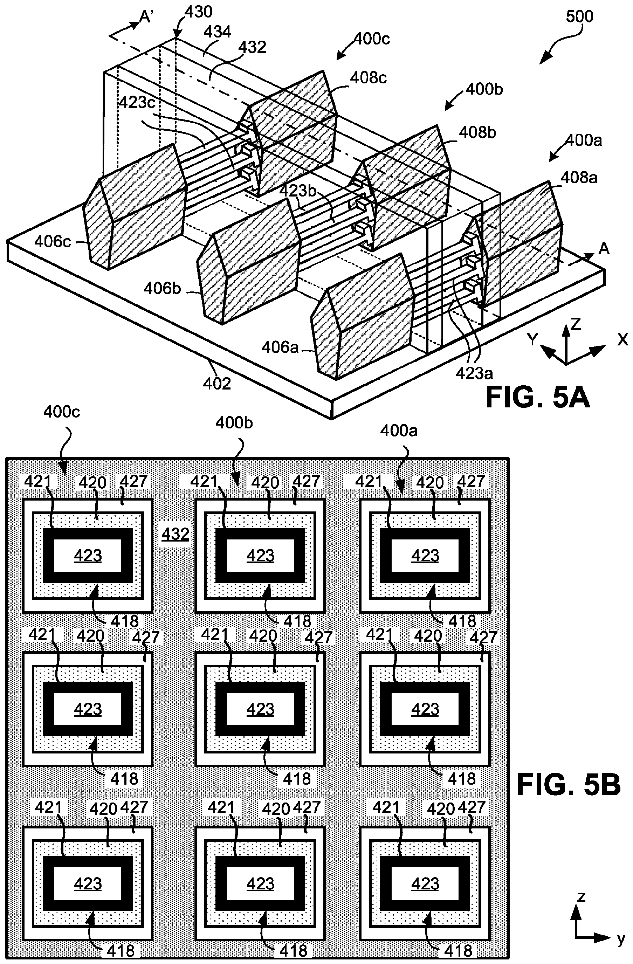

Fig. 5A illustrates perspective view of an integrated circuit (IC) structure 500 comprising non-planar devices 400a, 400b, 400c, where individual channel body of individual non-planar device 400 comprises a core structure 423 and a peripheral structure 421 at least in part wrapped around the core structure 423, in accordance with an embodiment of the present disclosure. Fig. 5B illustrates a cross-sectional view of the IC structure 500 comprising the non-planar devices 400a, 400b, 400c of Fig. 5A, in accordance with an embodiment of the present disclosure. The cross-sectional view of Fig. 5B is along line A-A' of Fig. 5A, which is the so called "gate cut" view of the devices 400a, 400b, 400c.

Each of the devices 400a, 400b, 400c of Figs. 5A and 5B have a structure that is similar to a structure of the device 400 of Figs. 4A-4F. For example, individual channel body 418 (such as nanoribbon 418) of individual ones of the devices 400a, 400b, 400c comprises a core structure 423 and a peripheral structure 421 wrapped around the core structure 423.

In one example, the devices 400a and 400c are PMOS devices, whereas the device 400b is an NMOS device. In another example, the devices 400a and 400c are NMOS devices, whereas the device 400b is a PMOS device.

Depending on whether a device 400 of Figs. 5A and 5B is a PMOS device or an NMOS device, the material for the core structure 423 and the peripheral structure 421 may be selected, for example, in accordance with the previously discussed Table 1.

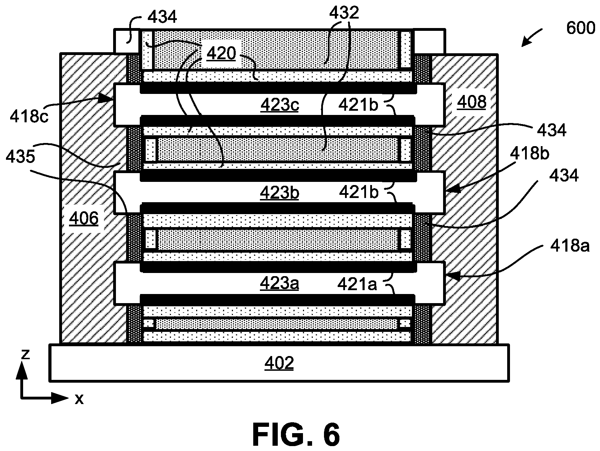

Fig. 6 illustrates cross-sectional view of a non-planar device 600, where (i) inner gate spacers 435 of the non-planar device 600 are recessed, such that a source region 406 and a drain region 408 of the non-planar device 600 at least in part clad tip regions of a channel body 418 of the non-planar device 600 on multiple sides, and (ii) individual channel body 418 of the non-planar device 600 comprises a core structure 423 and a peripheral structure 421 at least in part wrapped around the core structure 423, in accordance with an embodiment of the present disclosure.

Thus, Fig. 6 includes features of the device 100 of Figs. 1A-1D and features of Figs. 4A-4F. For example, similar to the device 100 of Figs. 1A-1D, in the device 600 of Fig. 6, inner gate spacers 435 of the non-planar device 600 are recessed, such that the source region 406 and the drain region 408 of the non-planar device 600 at least in part clad tip regions of the channel body 418 of the non-planar device 600 on multiple sides. Furthermore, similar to the device 400 of Figs. 4A-4F, in the device 600 of Fig. 6, individual channel body 418 of the non-planar device 400 comprises the core structure 423 and the peripheral structure 421 at least in part wrapped around the core structure 423.

Structure and formation of the device 600 of Fig. 6 will be apparent based on the discussion with respect to the devices 100 and 400 discussed throughout this disclosure.

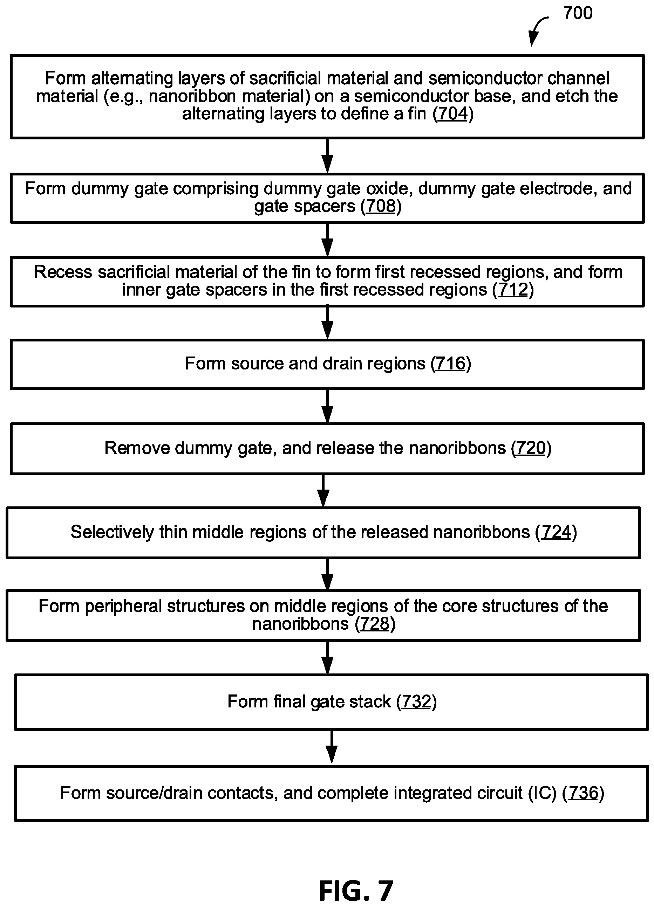

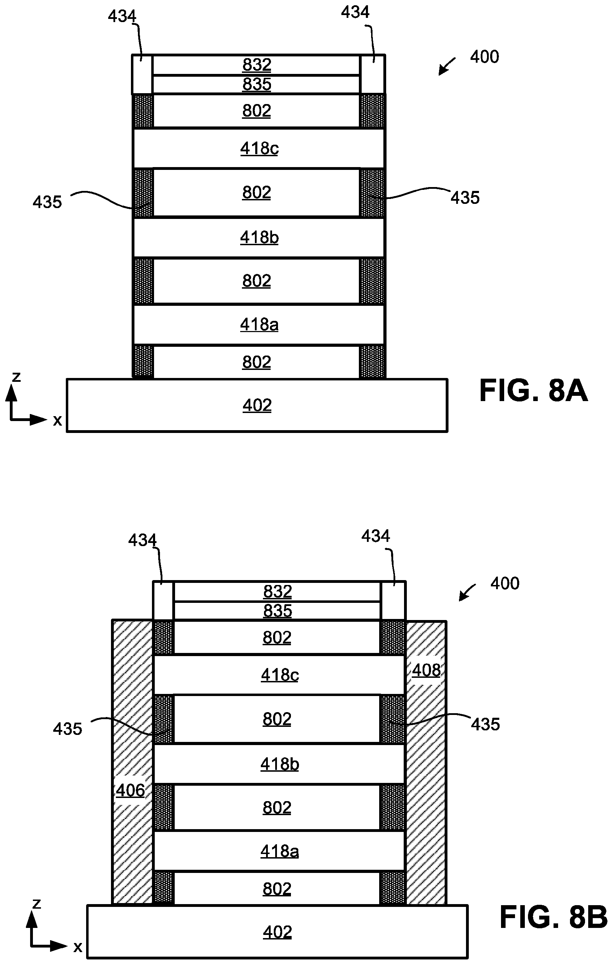

Fig. 7 illustrates a flowchart depicting a method 700 of forming the example non-planar device 400 of Figs. 4A-4F, in accordance with an embodiment of the present disclosure. Figs. 8A-8F illustrate cross-sectional views of an example non-planar device (e.g., the non-planar device 400 of Figs. 4A-4F) in various stages of processing, in accordance with an embodiment of the present disclosure. Figs. 7 and 8A-8F will be discussed in unison.

Referring to Fig. 7, the method 700 includes processes 704, 708, and 712, which are similar to the processes 204, 208, and 212, respectively, of the method 200 of Fig. 2. Accordingly, processes 704, 708, and 712 are not discussed in further detail herein. The process 712 forms the device of Fig. 8A, which is similar to the device of Fig. 3D formed by the process 212 of the method 200 of Fig. 2. For example, similar to the device of Fig. 3D, the device 400 of Fig. 8A includes dummy gate electrode 832, dummy gate oxide 835, gate spacers 434, inner gate spacers 435, sacrificial material 802, channel body material (e.g., nanoribbons) 418a, 418b, 418c, and the base 402.

Referring again to Fig. 7, the method 700 then proceeds from 712 to 716, where source and drain regions are formed. For example, the source and drain regions are epitaxially deposited. Fig. 8B illustrates the source region 406 and drain region 408.

In one embodiment, forming the source and drain regions can be performed by etching at least a portion of the exposed source and drain portion of the fins to remove the layer stack, and forming replacement source and drain material using any suitable techniques, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example. In some embodiments, the exposed source/drain regions of the fins need not be completely removed; instead, the material in the layer stack at the source/drain regions is converted to final source/drain regions by doping, implantation, and/or cladding with a source/drain material or other suitable processing, for example.

In some embodiments, the source and drain regions may be formed one polarity at a time, such as performing processing for one of n-type and p-type regions, and then performing processing for the other of the n-type and p-type regions. In some embodiments, the source and drain regions may include any suitable doping scheme, such as including suitable n-type and/or p-type dopant (e.g., in a concentration in the range of 1E16 to 1E22 atoms per cubic cm). However, in some embodiments, at least one source or drain region may be undoped/intrinsic or relatively minimally doped, such as including a dopant concentration of less than 1E16 atoms per cubic cm, for example.

Referring again to Fig. 7, the method 700 then proceeds from 716 to 720, which comprises removing the dummy gate, and releasing nanoribbons in the channel region. Fig. 8C illustrates the device 400, with the dummy gate oxide 835 and dummy gate electrode 832 removed, and the nanoribbons 518 released by removing the sacrificial material 802. The process 720 is similar to the process 224 of the method 200 of Fig. 2, and hence, is not discussed in further detail.

Referring again to Fig. 7, the method 700 then proceeds from 720 to 724, which comprises selectively thinning the middle regions of the nanoribbons, e.g., to form the core structures of the nanoribbons. Fig. 8D illustrates the nanoribbons after being thinned. For example, middle regions 480 (see Figs. 4C-4F) of the nanoribbons 418 are thinned. An etching process, such as atomic layer etch (ALE), a wet etch process, an anisotropic dry etch, or other suitable etch process may be employed. The etchant may be selectively to the inner gate spacer 435 (e.g., which may comprise silicon nitride), i.e., the etchant etches the nanoribbons 418, without etching the inner gate spacer 435. In an example, the tip regions 418 (see Figs. 4C-4F) of the nanoribbons 418 may be protected by the inner gate spacers 435 from being thinned or removed.

After thinning of a nanoribbon 418, the resultant nanoribbon structure is the core structure 423 of the nanoribbon, as illustrated in Fig. 8D. Thus, as also discussed with respect to Figs. 4A-4F and as illustrated in Fig. 8D, after thinning, the core structure 423 has the middle region 480 that is thinner than the tip regions 418. For example, as also discussed with respect to Figs. 4A-4F, the core structure 423 now has a shape of a dumb-bell or an "H".

Referring again to Fig. 7, the method 700 then proceeds from 724 to 728, where peripheral structures are formed (e.g., deposited) on middle regions of the core structures of the nanoribbons. Fig. 8E illustrates the peripheral structures 421 formed on the core structures 423 of the nanoribbons 418. While Fig. 8E (which is similar to Fig. 4C) illustrates one example geometry of the peripheral structures 421 and the core structures 423, Figs. 4D and 4E illustrate other example geometries of the peripheral structures 421 and the core structures 423. In one embodiment, the formation process 728 can be performed using any suitable deposition technique, such as such as CVD, PVD, ALD, VPE, MBE, or LPE, for example.

Example materials for the peripheral structures 421 and the core structures 423 have been discussed with respect to Table 1 herein previously. In an example where PMOS and NMOS are to be cointegrated, the peripheral structure may be formed one polarity at a time, such as performing processing for one of n-type and p-type regions, and then performing processing for the other of the n-type and p-type regions.

Referring again to Fig. 7, the method 700 then proceeds from 728 to 732, which comprises forming a final gate stack. For example, Fig. 8F illustrates the device 400, with the corresponding gate stack formed. For example, the gate stack of the device 400 comprises gate dielectric 420 wrapped around middle regions of individual nanoribbons 418, and the gate electrode 432 around the gate dielectric 420. The process 732 is similar to the process 228 of the method 200 of Fig. 2, and hence, is not discussed in further detail.

Referring again to Fig. 7, the method 700 then proceeds from 732 to 736, which comprises forming corresponding source/drain contacts and completing the IC. The process 736 is similar to the process 232 of the method 200 of Fig. 2, and hence, is not discussed in further detail.

Note that the processes in method 700 are shown in a particular order for ease of description. However, one or more of the processes may be performed in a different order or may not be performed at all (and thus be optional), in accordance with some embodiments. Numerous variations on method 700 and the techniques described herein will be apparent in light of this disclosure.

### Example System

Fig. 8 illustrates a computing system 1000 implemented with integrated circuit structures and/or transistor devices formed using the techniques disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices formed using the disclosed techniques in accordance with an example embodiment. In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices formed using the disclosed techniques as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

### Further Example Embodiments

The following clauses pertain to further embodiments, from which numerous permutations and configurations will be apparent.

Example 1. A semiconductor structure comprising: a body comprising a semiconductor material; a gate structure at least in part wrapped around the body, the gate structure including (i) a gate electrode and (ii) a gate dielectric between the body and the gate electrode; and a source region and a drain region, the body laterally extending between the source and drain regions, wherein the body has a first tip region, a second tip region, and a middle region between the first and second tip regions, and wherein the source region at least in part wraps around the first tip region of the body, and/or the drain region at least in part wraps around the second tip region of the body.

Example 2. The semiconductor structure of example 1, wherein the source region at least in part wraps around the first tip region of the body and the drain region at least in part wraps around the second tip region of the body.

Example 3. The semiconductor structure of any one of examples 1-2, wherein the body is a first body, the middle region is a first middle region, and wherein the semiconductor structure further comprises: a second body comprising a semiconductor material and laterally extending between the source and drain regions, wherein the second body has a third tip region, a fourth tip region, and a second middle region between the third and fourth tip regions, wherein at least a section of the source region is vertically between the first tip region of the first body and the third tip region of the second body.

Example 4. The semiconductor structure of example 3, wherein at least a section of the drain region is vertically between the second tip region of the first body and the fourth tip region of the second body.

Example 5. The semiconductor structure of any one of examples 1-4, wherein the source region includes a grain boundary or seam between adjacent sections of the source region, and/or the drain region includes a grain boundary or seam between adjacent sections of the drain region.

Example 6. The semiconductor structure of any one of examples 1-5, wherein: the body has a first near-tip region laterally between the first tip region and the middle region, and a second near-tip region laterally between the second tip region and the middle region; the semiconductor structure further comprises a first inner gate spacer between the gate electrode and the source region, and a second inner gate spacer between the gate electrode and the drain region; and the first inner gate spacer above and below the first near-tip region.

Example 7. The semiconductor structure of example 6, wherein the second inner gate spacer is above and below the second near-tip region.

Example 8. The semiconductor structure of any one of examples 6-7, further comprising: a first gate spacer and a second gate spacer, an upper section of the gate electrode between the first and second gate spacers, wherein a width of the first gate spacer is at least 5% more than a width of the first inner gate spacer, the width measured in a direction that is parallel to a length of the body.

Example 9. The semiconductor structure of example 8, wherein a width of the second gate spacer is at least 10% more than a width of the second inner gate spacer.

Example 10. The semiconductor structure of any one of examples 1-9, wherein the body is a first body, and wherein the semiconductor structure further comprises: a plurality of bodies including the first body, each body of the plurality of bodies comprises a corresponding first tip region, a corresponding second tip region, and a corresponding middle region laterally between the corresponding first and second tip regions, wherein the source region at least in part wraps around the first tip region of each of the plurality of bodies.

Example 11. The semiconductor structure of example 10, wherein the drain region at least in part wraps around the second tip region of each of the plurality of bodies.

Example 12. The semiconductor structure of any one of examples 1-11, wherein: the body comprises (i) a core structure that includes the first tip region, the second tip region, and a section of the middle region, and (ii) a peripheral structure that includes another section of the middle region, the peripheral structure compositionally different from the core structure.

Example 13. The semiconductor structure of example 12, wherein the peripheral structure wraps around the core structure in the middle region of the body.

Example 14. The semiconductor structure of any one of examples 12-13, wherein: the core structure comprises group IV semiconductor material; and the peripheral structure comprises group III-V semiconductor material.

Example 15. The semiconductor structure of any one of examples 12-14, wherein: the core structure comprises group IV semiconductor material; and the peripheral structure comprises group IV semiconductor material.

Example 16. The semiconductor structure of any one of examples 1-15, wherein the body is a nanowire, a nanoribbon, or a nanosheet.

Example 17. The semiconductor structure of any one of examples 1-16, wherein the body is part of a vertical stack including two or more nanosheets or nanoribbons.

Example 18. The semiconductor structure of any one of examples 1-17, wherein the semiconductor structure is a gate-all-around transistor device.

Example 19. The semiconductor structure of any one of examples 1-18, wherein the semiconductor structure is a forksheet transistor.

Example 20. A semiconductor structure comprising: a body comprising a semiconductor material; a gate structure at least in part wrapped around the body, the gate structure including (i) a gate electrode and (ii) a gate dielectric between the body and the gate electrode; and a source region and a drain region, the body laterally extending between the source and drain regions, wherein the body has a first tip region, a second tip region, and a middle region laterally between the first and second tip regions, wherein the body comprises (i) a core structure that includes the first tip region, the second tip region, and a section of the middle region, and (ii) a peripheral structure that includes another section of the middle region, the peripheral structure compositionally different from the core structure, and wherein the peripheral structure wraps around the core structure in the middle region of the body.

Example 21. The semiconductor structure of example 20, wherein: the core structure comprises a continuous section having one end abutting the source region and another end abutting the drain region; the peripheral structure is confined within the middle region of the body and is absent from the first and second tip regions of the body; and the peripheral structure is in between and separates the gate dielectric and the core structure.

Example 22. The semiconductor structure of any one of examples 20-21, wherein: the core structure has a first vertical height in the first tip region and a second vertical height in the middle region, wherein the first and second vertical heights are measured in a direction that is perpendicular to a length of the body; and the first vertical height is at least 5% more than the second vertical height.

Example 23. The semiconductor structure of example 22, wherein the first vertical height is at least 10% more than the second vertical height.

Example 24. The semiconductor structure of any one of examples 20-23, wherein: a first vertical height of the middle region of the body is within 5% of a second vertical height of the first tip region of the body, wherein the first and second vertical heights are measured in a direction that is perpendicular to a length of the body.

Example 25. The semiconductor structure of any one of examples 20-24, wherein: the core structure comprises group IV semiconductor material; and the peripheral structure comprises group III-V semiconductor material

Example 26. The semiconductor structure of any one of examples 20-25, wherein: the core structure comprises group IV semiconductor material; and the peripheral structure comprises group IV semiconductor material.

Example 27. The semiconductor structure of any one of examples 20-26, wherein: the core structure comprises silicon and lacks germanium; and the peripheral structure comprises silicon and germanium.

Example 28. The semiconductor structure of any one of examples 20-26, wherein: the core structure comprises silicon and germanium; and the peripheral structure comprises germanium and lacks silicon.

Example 29. The semiconductor structure of any one of examples 20-26, wherein: the core structure comprises silicon and germanium; and the peripheral structure comprises silicon and lacks germanium.

Example 29. The semiconductor structure of any one of examples 20-26, wherein: the core structure comprises silicon and germanium; and the peripheral structure comprises silicon and germanium, wherein a concentration of germanium in the peripheral structure is different from a concentration of germanium in the core structure.

Example 30. The semiconductor structure of any one of examples 20-26, wherein: the core structure comprises silicon and germanium; the peripheral structure comprises silicon and germanium; and a concentration of germanium in the peripheral structure is higher than a concentration of germanium in the core structure.

Example 31. The semiconductor structure of any one of examples 20-26, wherein: the core structure comprises silicon and germanium; and the peripheral structure comprises one or more of indium, gallium, and arsenide.

Example 32. The semiconductor structure of any one of examples 20-31, wherein: wherein the source region at least in part wraps around the first tip region of the body.

Example 33. The semiconductor structure of any one of examples 20-32, wherein the drain region at least in part wraps around the second tip region of the body.

Example 34. The semiconductor structure of any one of examples 20-33, wherein the body is a first body, the middle region is a first middle region, and wherein the semiconductor structure further comprises: a second body comprising a semiconductor material and laterally extending between the source and drain regions, wherein the second body has a third tip region, a fourth tip region, and a second middle region laterally between the first and second tip regions, wherein at least a section of the source region is vertically between the first tip region of the first body and the third tip region of the second body.

Example 35. The semiconductor structure of any one of examples 20-34, wherein the body is a nanowire, a nanoribbon, or a nanosheet.

Example 36. The semiconductor structure of any one of examples 20-35, wherein the body is part of a vertical stack including two or more nanosheets or nanoribbons.

Example 37. The semiconductor structure of any one of examples 20-36, wherein the semiconductor structure is a gate-all-around transistor device.

Example 38. The semiconductor structure of any one of examples 20-37, wherein the semiconductor structure is a forksheet transistor.

Example 39. An integrated circuit structure comprising: a first non-planar semiconductor device comprising a first source region and a first drain region, and a first body laterally extending between the first source region and the first drain region, the first body comprising (i) a first core structure including a continuous section with a first end abutting the first source region and a second end abutting the first drain region, and (ii) a first peripheral structure wrapped around a middle section of the first core structure; and a second non-planar semiconductor device comprising a second source region and a second drain region, and a second body laterally extending between the second source region and the second drain region, the second body comprising (i) a second core structure including a continuous section with a first end abutting the second source region and a second end abutting the second drain region, and (ii) a second peripheral structure wrapped around a middle section of the second core structure, wherein the first peripheral structure is compositionally different from the second peripheral structure.

Example 40. The integrated circuit structure of example 39, wherein the first peripheral structure is compositionally different from the first core structure.

Example 41. The integrated circuit structure of any one of examples 39-40, wherein the second peripheral structure is compositionally different from the second core structure.

Example 42. The integrated circuit structure of any one of examples 39-41, wherein: the first and second core structures comprises group IV semiconductor material; and at least one of the first or second peripheral structures comprises group IV semiconductor material.

Example 43. The integrated circuit structure of any one of examples 39-42, wherein: the first and second core structures comprises group IV semiconductor material; and at least one of the first or second peripheral structures comprises group III-IV semiconductor material.

Example 44. The integrated circuit structure of any one of examples 39-42, wherein: the first and second core structures comprises group IV semiconductor material; one of the first or second peripheral structures comprises group IV semiconductor material; and another of the first or second peripheral structures comprises group III-IV semiconductor material.

Example 45. The integrated circuit structure of any one of examples 39-42, wherein: the first and second core structures comprises silicon and lacks germanium; the first peripheral structure comprises silicon and germanium; and the second peripheral structure comprises silicon and lacks germanium.

Example 46. The integrated circuit structure of any one of examples 39-42, wherein: the first and second core structures comprises silicon and germanium; the first peripheral structure comprises silicon and germanium, wherein a concentration of germanium in the first peripheral structure is higher than a concentration of germanium in the first core structure; and the second peripheral structure comprises silicon and lacks germanium.

Example 47. The integrated circuit structure of any one of examples 39-42, wherein: the first and second core structures comprises silicon and germanium; the first peripheral structure comprises germanium and lacks silicon; and the second peripheral structure comprises indium, gallium, and arsenide.

Example 48. A method of forming a semiconductor structure, comprising: forming a plurality of bodies, each body including (i) a first tip region, (ii) a second tip region, (iii) a middle region laterally between the first and second tip regions, (iv) a first near-tip region laterally between the first tip region and the middle region, and (v) a second near-tip region laterally between the second tip region and the middle region; forming an inner gate spacer on a side of the plurality of bodies, such that the inner gate spacer is above and below the first tip region and the first near-tip region of each body of the plurality of bodies; recessing the first inner gate spacer to free the first tip regions of each body of the plurality of bodies, such that the recessed first inner gate spacer is above and below the first near-tip region of each body of the plurality of bodies and not above and below the first tip region of each body of the plurality of bodies; and forming a source region that wraps around the first tip region of each body of the plurality of bodies.

Example 49. The method of example 48, wherein at least a section of the source region is vertically between first tip regions of two bodies of the plurality of bodies.

Example 50. The method of any one of examples 48-49, wherein the inner gate spacer is a first inner gate spacer, and wherein the method comprises: forming a second inner gate spacer on another side of the plurality of bodies, such that the second inner gate spacer is above and below the second tip region and the second near-tip region of each body of the plurality of bodies; recessing the second inner gate spacer to free the second tip regions of each body of the plurality of bodies, such that the recessed second inner gate spacer is above and below the second near-tip region of each body of the plurality of bodies and is not above and below the second tip region of each body of the plurality of bodies; and forming a drain region that wraps around the second tip region of each body of the plurality of bodies.

Example 51. The method of example 50, wherein at least a section of the drain region is vertically between second tip regions of two bodies of the plurality of bodies.

Example 52. The method of any one of examples 48-51, wherein the first tip region of each body of the plurality of bodies extend within the source region.

Example 53. A method of forming a semiconductor structure, comprising: forming a core structure of a body, the core structure having a first tip region, a second tip region, a middle region laterally between the first and second tip regions; forming a first inner gate spacer that is above and below the first tip region of the core structure, and a second inner gate spacer that is above and below the second tip region of the core structure; thinning the middle region of the core structure, to form a thinned middle region of the core structure; and forming a peripheral structure of the body that at least in part wraps around the thinned middle region of the core structure.

Example 54. The method of example 53, further comprising: forming a gate stack that includes (i) gate dielectric layer at least in part wrapped around the peripheral structure, and (ii) a gate electrode at least in part wrapped around the gate dielectric.

Example 55. The method of example 54, wherein the peripheral structure separates the gate dielectric from the core structure.

Example 56. The method of any one of examples 53-55, further comprising: forming a source region and a drain region, such that the body laterally extends between the source region and the drain region.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner, and may generally include any set of one or more limitations as variously disclosed or otherwise demonstrated herein.

## Claims

1. A semiconductor structure comprising:
a body comprising a semiconductor material;
a gate structure at least in part wrapped around the body, the gate structure including (i) a gate electrode and (ii) a gate dielectric between the body and the gate electrode; and
a source region and a drain region, the body laterally extending between the source and drain regions,
wherein the body has a first tip region, a second tip region, and a middle region between the first and second tip regions, and
wherein the source region at least in part wraps around the first tip region of the body, and/or the drain region at least in part wraps around the second tip region of the body.

2. The semiconductor structure of claim 1, wherein the source region at least in part wraps around the first tip region of the body and the drain region at least in part wraps around the second tip region of the body.

3. The semiconductor structure of claim 1 or 2, wherein the body is a first body, the middle region is a first middle region, and wherein the semiconductor structure further comprises:
a second body comprising a semiconductor material and laterally extending between the source and drain regions, wherein the second body has a third tip region, a fourth tip region, and a second middle region between the third and fourth tip regions,
wherein at least a section of the source region is vertically between the first tip region of the first body and the third tip region of the second body.

4. The semiconductor structure of claim 3, wherein at least a section of the drain region is vertically between the second tip region of the first body and the fourth tip region of the second body.

5. The semiconductor structure of any one of claims 1 through 4, wherein the source region includes a grain boundary or seam between adjacent sections of the source region, and/or the drain region includes a grain boundary or seam between adjacent sections of the drain region.

6. The semiconductor structure of any one of claims 1 through 5, wherein:
the body has a first near-tip region laterally between the first tip region and the middle region, and a second near-tip region laterally between the second tip region and the middle region;
the semiconductor structure further comprises a first inner gate spacer between the gate electrode and the source region, and a second inner gate spacer between the gate electrode and the drain region; and
the first inner gate spacer above and below the first near-tip region.

7. The semiconductor structure of claim 6, wherein the second inner gate spacer is above and below the second near-tip region.

8. The semiconductor structure of claim 6 or 7, further comprising:
a first gate spacer and a second gate spacer, an upper section of the gate electrode between the first and second gate spacers,
wherein a width of the first gate spacer is at least 5% more than a width of the first inner gate spacer, the width measured in a direction that is parallel to a length of the body.

9. The semiconductor structure of claim 8, wherein a width of the second gate spacer is at least 10% more than a width of the second inner gate spacer.

10. The semiconductor structure of any one of claims 1 through 9, wherein the body is a first body, and wherein the semiconductor structure further comprises: a plurality of bodies including the first body, each body of the plurality of bodies comprises a corresponding first tip region, a corresponding second tip region, and a corresponding middle region laterally between the corresponding first and second tip regions, wherein the source region at least in part wraps around the first tip region of each of the plurality of bodies.

11. The semiconductor structure of claim 10, wherein the drain region at least in part wraps around the second tip region of each of the plurality of bodies.

12. The semiconductor structure of any one of claims 1 through 11, wherein:
the body comprises (i) a core structure that includes the first tip region, the second tip region, and a section of the middle region, and (ii) a peripheral structure that includes another section of the middle region, the peripheral structure compositionally different from the core structure.

13. The semiconductor structure of claim 12, wherein the peripheral structure wraps around the core structure in the middle region of the body.

14. The semiconductor structure of claim 12 or 13, wherein:
the core structure comprises group IV semiconductor material; and
the peripheral structure comprises group III-V semiconductor material.

15. The semiconductor structure of any one of claims 1 through 14, wherein the body is part of a vertical stack including two or more nanosheets or nanoribbons.
